(19) Europäisches Patentamt
European Patent Office
Office européen des brevets

(11) **EP 1 845 417 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(51) Int Cl.:
*G03F 7/20* (2006.01)  *H01L 21/00* (2006.01)

(21) Anmeldenummer: **07006340.9**

(22) Anmeldetag: **28.03.2007**

(54) **Beleuchtungssystem mit Zoomobjetiv**

Illumination system with zoom lens

Système d'éclairage doté d'un objectif à zoom

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **11.04.2006 DE 102006017336**
**11.04.2006 US 793995 P**

(43) Veröffentlichungstag der Anmeldung:
**17.10.2007 Patentblatt 2007/42**

(73) Patentinhaber: **Carl Zeiss SMT GmbH**
**73447 Oberkochen (DE)**

(72) Erfinder:
• **Singer, Wolfgang, Dr.**
**73431 Aalen (DE)**
• **Ossmann, Jens**
**73430 Aalen (DE)**

(74) Vertreter: **Carl Zeiss AG - Patentabteilung**
**Carl-Zeiss-Strasse 22**
**73447 Oberkochen (DE)**

(56) Entgegenhaltungen:
**EP-A- 1 319 983    US-A1- 2003 043 455**
**US-A1- 2004 108 467    US-B2- 6 658 084**

**Beschreibung**

Gebiet der Erfindung

Die Erfindung betrifft ein Beleuchtungssystem aufgebaut um mit Strahlung einer Lichtquelle ein Feld in einer Feldebene und gleichzeitig eine Pupillenebene auszuleuchten.

Hintergrund der Erfindung

Generell kann man bei optischen Elementen, die in einem Beleuchtungssystem oder einem Projektionsobjektiv einer Projektionsbelichtungsanlage Verwendung finden zwischen zwei unterschiedlichen Klassen unterscheiden, sog. dioptrischen Elementen und katoptrischen Elementen. Dioptrische Elemente sind refraktive Elemente, bspw. Linsenelemente, katoptrische Elemente sind reflektive Elemente, bspw. Spiegelelemente. Verwendet ein Beleuchtungssystem oder ein Projektionsobjektiv ausschließlich dioptrische Elemente so wird es als dioptrisches Beleuchtungssystem oder als dioptrisches Projektionsobjektiv bezeichnet, verwendet es ausschließlich katoptrische Elemente, so wird es als katoptrisches Projektionsobjektiv oder katoptrisches Beleuchtungssystem bezeichnet und verwendet es sowohl refraktive wie auch reflektive Elemente, so wird ein solches Beleuchtungssystem oder Projektionsobjektiv als katadioptrisches Beleuchtungssystem oder katadioptrisches Projektionsobjektiv bezeichnet.

Um die Strukturweiten von elektronischen Bauteilen weiter zu reduzieren, insbesondere in den sub-$\mu$m-Bereich ist es vorteilhaft, die Wellenlängen des Lichtes die im Bereich der Mikrolithographie eingesetzt werden, zu reduzieren. Bevorzugt wird für die Herstellung derartiger Strukturen Licht mit Wellenlängen von $\leq 193$ nm sogenannte VUV (Very Deep UV-light)-Strahlung oder weiße Röntgenstrahlung sogenannte EUV (Extreme UV-light)-Strahlung eingesetzt.

Beleuchtungssysteme für Projektionsbelichtungsanlagen, die derartige Strahlung verwenden, sind aus einer Vielzahl von Schriften bekannt geworden. So zeigt die US 6,198,793 bzw. die US 6,438,199 ein Beleuchtungssystem zur Beleuchtung eines Feldes in einer Feldebene und zur Ausleuchtung einer Austrittspupille, wobei das Beleuchtungssystem ein erstes facettiertes optisches Element aufweist, das im Wesentlichen rechteckige Rasterelemente zeigt. Die Formung des Feldes erfolgt bei den Systemen gemäß der US 6,198,793 bzw. der US 6,438,199 mit Hilfe eines grazing-incidence-Spiegels.

Aus der US 6,195,201 ist ebenfalls ein doppelt facettiertes Beleuchtungssystem bekannt geworden. Allerdings erfolgt bei diesem System die Formung des Feldes nicht mit Hilfe eines grazing-incidence-Spiegels, sondern die einzelnen Feldfacetten sind bereits in der Form des Feldes, nämlich bogenförmig bei einem auszuleuchtenden Ringfeld in der Feldebene, ausgebildet.

Die Veränderung der Ausleuchtung in der Pupille des Beleuchtungssystems, d.h. die Veränderung des Beleuchtungssettings ist aus nachfolgenden Anmeldungen bekannt geworden.

So ist in der US 6,658,084 beschrieben, dass unterschiedliche Ausleuchtungen, sog. Beleuchtungssettings in einer Pupillenebene bei einem doppelt facettierten Beleuchtungssystem durch Tausch des ersten facettierten optischen Elements eingestellt werden können. Nachteilig an derartigen Systemen ist allerdings, dass im Regelfall das zweite facettierte optische Element mehr Facetten umfassen muss als das erste facettierte optische Element, was eine aufwendige Fertigung zur Folge hat.

Alternativ hierzu können Blenden in der Ebene oder einer konjugierten Ebene des zweiten facettierten optischen Elementes, d.h. des facettierten optischen Elementes mit Pupillenfacetten, vorgesehen sein. Eine weitere Möglichkeit ist die Verwendung von Blenden, die einzelne der ersten Rasterelemente des ersten facettierten optischen Elementes ausblenden. Dies führt jedoch im Regelfall zu Lichtverlusten.

Ein System, bei dem durch Variation der Ausleuchtung des Feldfacettenspiegels das Beleuchtungssetting geändert wird, ist aus der US 6,704,095 bekannt geworden. Die Ausleuchtung auf dem ersten Feldfacettenspiegel wird gemäß der US 6,704,095 auf unterschiedliche Art und Weise erreicht, beispielsweise durch einen grazing-incidence Spiegel oder aber auch durch ein Zoom-System, mit dem die Ausleuchtung des ersten Feldfacettenspiegels variiert werden kann.

Aus der US 5,237,367 ist für refraktive Beleuchtungssysteme, d.h. dioptrische Beleuchtungssysteme bekannt, die Ausleuchtung in der Pupille und damit das Beleuchtungssetting durch Verschieben eines facettierten dioptrischen Elementes in einer Pupillenebene zu ändern.

Ein Beleuchtungssystem für eine Projektionsbelichtungsanlage mit einer katoptrischen Gruppe, mit deren Hilfe die Ausleuchtung in der Pupillenebene variiert werden kann, ist aus der W02006/021419 bekannt geworden.

Ausleuchtungen in einer Pupillenebene, sog. Beleuchtungssetttings können unterschiedliche Formen aufweisen, beispielsweise eine kreisförmige, eine annulare oder multipolare Form. Für kreisförmige oder annulare Ausleuchtungen wird die Größe der Ausleuchtung in einer Pupillenebene durch einen Füllgrad $\sigma$ beschrieben. Definitonsgemäß ist der Füllgrad $\sigma = 1$, wenn die Pupille des Beleuchtungssystems vollständig ausgeleuchtet ist. Wenn die Pupille nicht vollständig ausgeleuchtet ist, so ist der Füllgrad $\sigma < 1$.

Die Definitionen für den Füllgrad sind dem Fachmann geläufig.

Für eine kreisförmige Ausleuchtung wird der Füllgrad σ definiert durch

$$\sigma = \frac{r}{R_{NA}}$$

wobei

r: der Radius der Ausleuchtung in der Austrittspupille ist.

$R_{NA}$: der Radius der numerischen Apertur NA des Beleuchtungssystems, die mit der objektseitigen numerischen Apertur NA des Projektionsobjektives einer Projektionsbelichtungsanlage übereinstimmt.

Aufgabe der Erfindung ist es, die Nachteile des Standes der Technik zu überwinden und ein Verfahren das insbesondere für Wellenlängen ≤ 193 nm, bevorzugt ≤ 100 nm, ganz bevorzugt im EUV-Bereich mit Wellenlängen < 14 nm geeignet ist, anzugeben, mit dem eine Ausleuchtung in der Austrittspupille, d. h. das Beleuchtungssetting variabel eingestellt werden kann, ohne dass die zuvor im Stand der Technik beschriebenen Nachteile auftreten.

Zusammenfassung der Erfindung

Diese Aufgabe wird gelöst durch ein Verfahren entsprechend Anspruch 1.

Ein Beleuchtungssystem ist derart aufgebaut, um mit Strahlung einer Lichtquelle, vorzugsweise einer Wellenlänge λ, ein Feld in einer Feldebene mit einer Beleuchtungsstärke auszuleuchten und eine Ausleuchtung mit einer Form und einer Größe in einer Pupillenebene zur Verfügung zu stellen., Das Beleuchtungssystem umfasst eine Vielzahl von Elementen, die derart angeordnet sind, dass Strahlung von der Lichtquelle zur Feldebene und zur Pupillenebene geleitet wird, wobei das Beleuchtungssystem ein katoptrisches Beleuchtungssystem ist und die Größe der Ausleuchtung in der Pupillenebene kontinuierlich variiert werden kann. Bevorzugt bleiben die Form der Ausleuchtung in der Pupillenebene sowie die Ausleuchtung in der Feldebene hierbei weitgehend unverändert. Ganz bevorzugt kann die Größe der Ausleuchtung in der Pupillenebene um ± 10%, bevorzugt um ± 25%, insbesondere bevorzugt um ± 40% kontinuierlich variiert werden.

Unter der allgemeinen Formulierung ",Ausleuchtung in der Feldebene" wird sowohl die Feldform, die Feldgröße und die Intensitätsverteilung (Beleuchtungsstärke) im Feld verstanden.

Die kontinuierliche Variation der Ausleuchtung wird dadurch erreicht, dass der Abstand zwischen wenigstens zwei optischen Elementen der Vielzahl von optischen Elementen veränderbar ist und die zwei optischen Elemente wenigstens ein facettiertes optisches Element umfassen.

Die hier beschriebenen Beleuchtungssysteme und Projektionsbelichtungsanlagen können für den Betrieb bei einer Vielzahl von unterschiedlichen Wellenlängen ausgelegt sein, bspw. Wellenlängen im UV oder DUV-Bereich. Ganz besonders bevorzugt sind die Ausführungsbeispiele für den Betrieb bei EUV-Wellenlängen ausgelegt. In einer weiteren Ausgestaltung der Erfindung können Ausführungsbeispiele für die Verwendung bei einer oder mehrerer Wellenlängen oder in einem Wellenlängenbereich ausgelegt sein.

Bevorzugt ist ein katoptrisches Beleuchtungssystem für Wellenlänge λ ≤ 193 nm, insbesondere ≤ 100 nm, besonders bevorzugt ≤ 14 nm ausgelegt.

Die Beleuchtungssettings können unterschiedliche Form aufweisen, beispielsweise eine kreisförmige, eine annulare oder eine multipolare Form, beispielsweise die eines Quadrupols.

Die Form der Ausleuchtung in der Pupillenebene eines Beleuchtungssystems kann in einer bevorzugten Ausführungsform der Erfindung voreingestellt werden, beispielsweise wie in der US 6,658,084 beschrieben, durch Tausch von optischen Elementen, beispielsweise des ersten facettierten optischen Elementes mit Rasterelementen. Hierfür kann das erste facettierte optische Element beispielsweise auf einem Wechselrad angeordnet sein. Mit Hilfe der Voreinstellung des Settings kann die Form des Settings bestimmt werden, beispielsweise, ob es sich um ein annulares oder kreisförmiges Setting handelt. Mit Hilfe der Erfindung ist es möglich, die Größe der Ausleuchtung in der Pupillenebene zu variieren, wobei die Form der Ausleuchtung bzw. des Settings weitgehend unverändert bleibt.

Die Vielzahl von Elementen des Beleuchtungssystems umfassen ein erstes facettiertes optisches Element und ein zweites facettiertes optisches Element. Das erste facettierte optische Element und das zweite facettierte optische Element umfasst im Falle, dass diese als katoptrische Elemente ausgebildet sind, je einen Spiegelträger auf dem eine Vielzahl von einzelnen Spiegelfacetten angeordnet sind.

Generell unterscheidet man bei reflektiven Systemen zwischen sog. normal-incidence-Elementen und grazing-incidence Elementen. Normal-incidence-Elemente sind solche Elemente bei denen die Einfallswinkel aller auf das Element auftreffenden Strahlen in Bezug zur Normalen am Auftreffpunkt ≤ 30°, bevorzugt ≤ 20°, ganz bevorzugt ≤ 10° ganz bevorzugt ≤ 5° ist. Grazing-incidence-Elemente sind solche Elemente, bei denen die Einfallswinkel aller auf das Element auftreffenden Strahlen in Bezug zur Normalen am Auftreffpunkt ≥ 70°, bevorzugt ≥ 80°, ganz bevorzugt ≥ 85° sind. Ein normal incidence Element ist somit ein optisches Element mit nahezu senkrechtem Lichteinfall und ein grazing incidence Element ein optisches Element mit streifendem Lichteinfall.

Im Strahlengang von der Lichtquelle zur Feldebene sind die Vielzahl von Elementen bevorzugt derart angeordnet, dass die Strahlung, die von der Lichtquelle zur Feldebene und zur Pupillenebene geleitet wird auf die normal-incidence Elemente in der Meridionalebene des jeweiligen normal-incidence Elementes des Beleuchtungssystems unter einem maximalen Einfallswinkel ($\theta_{max(max)}$) auf eine Oberfläche eines jeden Elementes von weniger als 20°, bevorzugt weniger als 10°, ganz bevorzugt weniger als 5° auftrifft.

Um die Lichtquelle, die oftmals unerwünschte langwellige Strahlung oder Teilchen emittiert von den optischen Komponenten des Beleuchtungssystems trennen zu können, wird in einer bevorzugten Ausführungsform im Lichtweg des Beleuchtungssystems vor der Feldebene ein Zwischenbild der Lichtquelle ausgebildet.

Die Vielzahl von Elementen des Beleuchtungssystems umfassen eine erste Vielzahl von Elementen, die Strahlung von der Lichtquelle in das Zwischenbild leiten und eine zweite Vielzahl von Elementen, die Strahlung vom Zwischenbild zur Feldebene und zur Pupillenebene leiten.

Bevorzugt umfasst die zweite Vielzahl von Elementen normal-incidence Elemente und grazing incidence Elemente und in der Meridionalebene eines jeden optischen Elementes des Beleuchtungssystems weist die Strahlung einen maximalen Einfallswinkel ($\theta_{max(max)}$) auf eine Oberfläche eines jeden normal-incidence Elementes von weniger als 20°, bevorzugt weniger als 10°, ganz bevorzugt weniger als 5° auf, und auf eine Oberfläche eines jeden grazing-incidence Elementes von mehr als 70°, bevorzugt mehr als 80°, ganz bevorzugt mehr als 85° auf.

Gemäß einem weiteren Aspekt der Erfindung umfasst das Beleuchtungssystem eine erste optische Komponente, die ein erstes facettiertes optisches Element mit wenigstens einem ersten Rasterelement und ein zweites facettiertes optisches Element mit wenigstens einem zweiten Rasterelement aufweist, wobei das erste und das zweite facettierte optische Element einen Abstand zueinander haben.

Das erste facettierte optische Element wird in einer reflektiven Ausgestaltung auch als Feldwabenspiegel bezeichnet und das zweite facettierte optische Element in einer reflektiven Ausgestaltung als Pupillenwabenspiegel.

Des Weiteren umfasst das Beleuchtungssystem wenigstens eine zweite optische Komponente, die im Lichtweg von einer Lichtquelle zu einer Feldebene nach der ersten optischen Komponente angeordnet ist.

In dem Beleuchtungssystem ist eine erste Einstelleinrichtung vorgesehen, mit der der Abstand zwischen dem ersten facettierten optischen Element und dem zweiten facettierten optischen Element eingestellt werden kann, und eine zweite Einstelleinrichtung mit der die Brennweite der zweiten optischen Komponente eingestellt werden kann. Die Einstellung mit Hilfe der Einstelleinrichtung ist insbesondere auch im laufenden Betrieb der Lithographieanlage möglich; d.h. im laufenden Betrieb können durch Verfahren der jeweiligen optischen Komponenten unterschiedliche Beleuchtungssettings in der Pupillenebene eingestellt werden, ohne dass hierfür die Anlage für einen längeren Zeitraum außer Betrieb gesetzt werden muß.

Es ist der Verdienst der Erfinder erkannt zu haben, dass eine Einstellung der Ausleuchtung bzw. damit des Beleuchtungssettings in der Austrittspupille auch bei einem reflektiven, d. h. katoptrischen System durch Verschieben von optischen Komponenten möglich ist. Dies erschien bislang dem Fachmann nur sehr schwer möglich, da bei reflektiven Systemen eine eindeutige optische Achse für das Gesamtsystem, insbesondere für das Beleuchtungssystem nicht definiert werden kann. Insbesondere kann durch das Verschieben der optischen Komponente die Größe der Ausleuchtung in der Austrittspupille eingestellt werden, wobei die Form der Ausleuchtung aber weitgehend erhalten wird.

Die Brennweite der zweiten optische Komponente, die auch als Kondensoroptik bezeichnet wird, ist einstellbar, wodurch die Ausleuchtung, insbesondere die Größe der Ausleuchtung in einer Austrittspupillenebene und damit das Beleuchtungssetting des Beleuchtungssystems variiert werden kann. Die Kondensor-Optik ist als "Zoom-System" ausgebildet, das es ermöglicht die Ausleuchtung der Pupille und damit das Beleuchtungssetting variabel zu gestalten. Durch eine Änderung der Brennweite der zweiten optischen Komponente wird in der Regel auch die Feldabbildung, d.h. die Feldgröße beeinflusst. In dem vorliegenden System kann dies aber dadurch kompensiert werden, dass durch Änderung des Abstandes zwischen erstem facettierten optischen Element und zweitem facettierten optischen Element die Änderung der Feldabbildung kompensiert werden kann, ohne dass die Pupillenabbildung beeinflusst wird, da eine Änderung des Abstandes zwischen einem ersten facettierten optischen Element und einem zweiten facettierten optischen Element keinen Einfluß auf die Pupillenabbildung hat. Indem mit der ersten Einstellvorrichtung der Abstand zwischen erstem facettierten optischen Element und zweitem facettierten optischen Element geändert wird, kann die Feldausleuchtung konstant gehalten werden, selbst wenn die Pupillenausleuchtung geändert wird. In anderen Worten heißt dies, dass die Pupillenabbildung beeinflusst werden kann, ohne dass die Feldabbildung wesentlich beeinflusst wird. Unter dem allgemeinen Begriff "Ausleuchtung des Feldes" wird die Feldform, die Feldgröße und die Intensitätsverteilung bzw. die Beleuchtungsstärke im Feld verstanden.

Generell wird durch das erste facettierte optische Element mit Rasterelementen ein Strahlbüschel, das von der Lichtquelle her einfällt in eine Vielzahl von Strahlbüscheln aufgeteilt, die je einem Rasterelement zugeordnet sind.

Jedes Strahlbüschel, das einem ersten Rasterelement zugeordnet ist, weist je einen Schwerpunktstrahl auf. Der Schwerpunktstrahl ist in vorliegender Anmeldung der Strahl, der von der geometrischen Mitte eines ersten Rasterelementes ausgeht und die geometrische Mitte eines zweiten Rasterelements trifft. Da die ersten Rasterelemente die Abbildung in der Feldebene des Beleuchtungssystemes bestimmen, werden Sie auch als Feldrasterelemente bezeichnet. Bevorzugt ist das System derart ausgelegt, dass alle Schwerpunktstrahlen, die von den unterschiedlichen Feldrasterelementen ausgehen, im wesentlichen parallel zueinander verlaufen und auf die jeweiligen den ersten Rasterelementen zugeordneten zweiten Rasterelemente auftreffen, wobei diese Zuordnung auch bei Verschiebung von erstem facettierten optischen Element zu zweitem facettierten optischen Element sich nicht ändert. Damit bleibt die Kanalzuordnung von erstem Rasterelement zu zweitem Rasterelement auch bei Abstandsänderung invariant.

Sind die Strahlengänge der einzelnen Kanäle nicht parallel zueinander, so sind bevorzugt die einzelnen Feld- und Pupillenrasterelemente kippbar ausgelegt. Bei Verschiebung ändern sich dann die Kippwinkel und die Zuordnung von Feld- und Pupillenfacetten bleibt auch in einem derartigen Fall erhalten.

Besonders vorteilhaft ist es, wenn nur möglichst wenige optische Elemente verfahren werden. In einer weitergebildeten Ausgestaltung der Erfindung ist daher vorgesehen, dass mit Hilfe der ersten Einstelleinrichtung lediglich das zweite facettierte optische Element, der sogenannte Pupillenfacettenspiegel verfahren wird und so der Abstand zwischen erstem und zweitem facettierten optischen Element und zweitem facettierten optischen Element und erstem optischen Element variiert wird. Ein solches System hat den Vorteil, dass nur eine optische Komponente verfahren werden muss, so dass der mechanische Aufbau deutlich einfacher zu realisieren ist, da nur wenige Elemente mechanisch bewegt werden.

Ist das System ein System, bei dem genau zwei Zoomstellung realisiert werden, so ist es vorteilhaft, wenn mit Hilfe der ersten Einstelleinrichtung zur Variation des Abstandes das zweite facettierte optische Element von einer ersten Position in eine zweite Position verfahren wird und die Brennweite der ersten Rasterelemente so gewählt wird, dass das von den ersten Rasterelementen ausgebildete Zwischenbild der Lichtquelle im Wesentlichen genau in der Mitte zwischen erster Position und zweiter Position ausgebildet wird, d.h. sich mittig zwischen erster und zweiter Position befindet. Das zweite facettierte optische Element ist dann zwar defokussiert zum Zwischenbild und die einzelnen Pupillenrasterelemente des zweiten facettierten optischen Elementes werden beispielsweise im Wesentlichen elliptisch ausgeleuchtet. Die elliptische Ausleuchtung tritt im Falle eines kreisrunden, symmetrischen Zwischenfokus und ersten Rasterelementen, deren Aspektverhältnis von 1 abweicht, auf. Die Größe der ausgeleuchteten Bereiche in beiden Zoom-Stellungen stimmt bei einer derartigen Lage des Zwischenfokus weitgehend überein. Ist das Zwischenbild defokussiert, so ergibt sich die Größe der Ausleuchtung aus der Größe der Feldblende. In unserem Fall ist bspw. die Blende durch die Größe der Feldrasterelemente gegeben. Bei Feldrasterelemente die z.B. rechteckig sind mit einer Größe von 3x25mm, ändert sich die Ausleuchtung in der x-Richtung kaum, wohingegen die Ausleuchtung in y-Richtung lang gezogen wird. Daraus resultiert die ungefähr elliptische Form des Zwischenbildes der Lichtquelle.

Die Form der Pupillenrasterelementen können an die jeweilige Ausleuchtung in der ersten und/oder der zweiten Position des zweiten facettierten optischen Elementes angepasst sein, beispielsweise haben die zweiten Rasterelemente bzw. Pupillenrasterelemente eine elliptische Form.

Wie zuvor beschrieben wird in einer Feldebene des Beleuchtungssystems ein Feld ausgeleuchtet. Das Feld hat beispielsweise bogenförmige Form, die auch als Feldform bezeichnet wird.. In einem ersten Ausführungsbeispiel der Erfindung ist die Form der Feldfacetten, die auch als Facettenform der ersten Rasterelemente bezeichnet wird im Wesentlichen gleich der Feldform des ausgeleuchteten Feldes, d.h. beispielsweise bogenförmig.

Bei einem Beleuchtungssystem, bei dem die Feldfacetten im wesentlichen in Ihrer Form der Form des ausgeleuchteten Feldes entsprechen, ist es ausreichend, wenn die zweite optische Komponente des Beleuchtungssystems, mit der die Pupillenfacetten in die Austrittspupille des Beleuchtungssystems abgebildet werden, ein erstes und ein zweites optisches Element mit optischer Wirkung bzw. mit optischer Brechkraft umfasst.

Optional kann die zweite optische Komponente, falls das erste facettierte optische Element Feldrasterelemente aufweist, die in der Form des auszuleuchtenden Feldes in der Feldebene ausgebildet sind, auch noch ein drittes optisches Element ohne optische Wirkung bzw. Brechkraft, beispielsweise einen Planspiegel aufweisen.

Alternativ zu einem doppelt facettierten Beleuchtungssystem bei dem die Feldfacetten im Wesentlichen die Form des auszuleuchtenden Feldes aufweisen können die Feldfacetten auch rechteckig ausgebildet sein. In einem derartigen Fall umfasst die zweite optische Komponente wenigstens drei optische Elemente und die Feldformung erfolgt mit Hilfe der dritten optischen Komponente, die vorzugsweise ein grazing incidence Spiegel ist.

Um die Ausleuchtung in der Austrittspupille zu verändern, kann die Brennweite der zweiten optischen Komponente durch Verfahren und damit Änderung eines weiteren Abstandes (AB) zwischen einer oder mehrerer der nachfolgenden optischen Elemente variiert werden:

- dem zweiten facettierten optischen Element und dem ersten optischen Element.
- dem ersten optischen Element und dem zweiten optischen Element.
- dem zweiten optischen Element und dem dritten optischen Element.

- dem dritten optischen Element und der Feldebene.

Bevorzugt wird genau ein optisches Element der oben angegebenen mit Hilfe der zweiten Einstellvorrichtung verfahren. Bevorzugt ist dies das zweite optische Element der zweiten optischen Komponente. Durch das Verfahren dieses optischen Elementes wird der weitere Abstand (AB) zwischen dem erstem optischen Element und dem zweiten optischen Elemente sowie zwischen dem zweiten optischen Element und der Feldebene im Fall, dass die zweite optische Komponente zwei optische Elemente umfasst, oder zwischen zweitem optischen Element und drittem optischen Element für den Fall, dass die zweite optische Komponente drei optische Elemente umfasst, variiert.

Bevorzugt trifft bei dem erfindungsgemäßen Beleuchtungssystem in einer Meridionalebene des Beleuchtungssystems die Strahlung unter einem maximalen Einfallswinkel ($\theta_{max(max)}$) auf eine Oberfläche in einer Meridionalebene des ersten facettierten katoptrischen Elementes und/oder des zweiten facettierten katoptrischen Elementes von weniger als 20°, bevorzugt weniger als 10°, ganz bevorzugt weniger als 5° auf.

In einer besonderen Ausgestaltung wird der weitere Abstand (AB) um weniger als $\pm$ 20% variiert.

In einer weiteren Ausgestaltung wird der weitere Abstand (AB) derart variiert wird, dass sich ein der maximaler Einfallswinkel ($\theta_{max(max)}$) in einer Meridionalebene auf eine Oberfläche des zweiten facettierten katoptrischen Elementes und/oder des ersten optischen Elementes und/oder des zweiten optischen Elementes und/oder des dritten optischen Elementes um weniger als 5°, bevorzugt weniger als 3° ändert.

In einer weitergebildeten Ausführungsform umfasst das zweite facettierte katoptrische Element eine Fläche auf der ein oder mehrere der zweiten Rasterelemente angeordnet sind und die Fläche ist zu mehr als 80 %, bevorzugt mehr als 90 % ausgeleuchtet.

Die Erfindung stellt ein Verfahren zum Variieren der Ausleuchtung in der Austrittspupille eines Beleuchtungssystems, wobei die Größe der Ausleuchtung kontinuierlich variiert wird, die Form jedoch im Wesentlichen unverändert bleibt, zur Verfügung. Das Beleuchtungssystem umfasst hierfür beispielsweise eine erste optische Komponente, die ein erstes facettiertes optisches Element und ein zweites facettiertes optisches Element aufweist und eine zweite optische Komponente, die wenigstens ein erstes optisches Element und ein zweites optisches Element aufweist, wobei durch das Beleuchtungssystem ein Feld in einer Feldebene ausgeleuchtet wird. Das Verfahren zur Variation der Größe der Ausleuchtung umfasst die nachfolgend beschriebenen Schritte. Zunächst wird die Brennweite der zweiten optischen Komponente beispielsweise durch Verfahren wenigstens eines optischen Elementes der zweiten optischen Komponente variiert, ergebend eine Änderung der Ausleuchtung in der Austrittspupillenebene des Beleuchtungssystems. Beispielsweise wird durch ein Verfahren ein beispielsweise kreisförmiges Beleuchtungssetting mit einem ersten Füllgrad $\sigma(1)$ in ein Beleuchtungssetting mit einem zweiten Füllgrad $\sigma(2)$ geändert. Durch die Änderung der Brennweite wird aber nicht nur der Durchmesser der ausgeleuchteten Pupille und damit die Ausleuchtung bzw. der Füllgrad des kreisförmigen Settings in der Pupillenebene beeinflusst, sondern auch die Größe des ausgeleuchteten Feldes in der Feldebene. Um die Größe des ausgeleuchteten Feldes in der Feldebene konstant zu halten wird sodann der Abstand zwischen erstem und zweitem facettierten Element derart eingestellt, dass das ausgeleuchtete Feld in der Feldebene weitgehend konstant gehalten wird. Dies ist möglich, weil eine Variation des Abstandes von erstem facettierten optischen Element zu zweitem facettierten optischen Element keinerlei Einfluss auf die Größe der auszuleuchtenden Pupille in der Pupillenebene,hat .

Wie zuvor beschrieben ist es besonders vorteilhaft, wenn das zuvor beschriebene Verfahren mit dem die Größe der Ausleuchtung bei weitgehender Beibehaltung der Form der Ausleuchtung in der Pupillenebene kontinuierlich variiert werden kann, mit einem Verfahren zur Einstellung der Form der Ausleuchtung kombiniert wird.

Wird eine derartige Kombination vorgenommen, so kann durch das erfindungsgemäße Verfahren bei voreingestellter Form der Ausleuchtung in der Pupillenebene, d.h. der Form des Beleuchtungssettings, die Größe des Beleuchtungssettings durch das erfindungsgemäße Zoomsystem beispielsweise auf die Abbildungseigenschaften der Projektionsoptik optimiert werden. Die Form des Beleuchtungssettings kann beispielsweise durch Austausch der facettierten optischen Komponenten eingestellt werde.

Bevorzugt wird das Verfahren zum kontinuierlichen Variieren einer Ausleuchtung mit einer Form in einer Pupillenebene eines Beleuchtungssystems, wobei die Form der Ausleuchtung in der Pupillenebene weitgehend erhalten bleibt und die Ausleuchtung in der Pupillenebene eine erste Größe hat, mit folgenden Schritten durchgeführt:

- in einem ersten Schritt wird die Brennweite der zweiten optischen Komponente ergebend eine Ausleuchtung in der Pupillenebene mit einer zweiten Größe eingestellt;
- in einem darauf folgenden Verfahrensschritt wird ein Abstand zwischen einem ersten und einem zweiten facettierten Element derart eingestellt, dass die Ausleuchtung in der Feldebene, die sich bei der zweiten Größe ergibt, mit der Ausleuchtung in der Feldebene, die sich bei der ersten Größe ergibt, weitgehend übereinstimmt, oder umgekehrt.

Bevorzugt angewandt wird das Verfahren, wenn die Nutzstrahlung eine Wellenlänge $\lambda$ aufweist und die Wellenlänge $\lambda \leq 193$ nm, bevorzugt $\lambda \leq 14$ nm ist.

In einer besonderen Ausgestaltung der Erfindung ist die Verfahrensführung derart, dass die zweite Größe gegenüber der ersten Größe um maximal $\pm$ 10 %, bevorzugt um maximal $\pm$ 25 %, insbesondere bevorzugt um maximal $\pm$ 40 % variiert.

Die Ausleuchtung in der Pupillenebene kann beispielsweise kreisförmig, annular oder multipolar, insbesondere dipolar oder quadrupolar sein.

In einer besonderen Ausgestaltung der Erfindung, in der die Größe der Ausleuchtung in der Pupillenebene durch einen Füllgard $\sigma$ charakerisiert wird und die erste Größe der Ausleuchtung in der Pupillenebene einem ersten Füllgrad $\sigma$ (1) und die zweite Größe der Ausleuchtung in der Pupillenebene einem zweiten Füllgrad $\sigma$ (2) entspricht gilt:

$\sigma$ (2) variiert um $\pm$ 40% gegenüber $\sigma$(1), d.h. $\sigma$(2) liegt im Bereich

$$(1 + 0{,}40) \cdot \sigma(1) > \sigma(2) > (1 - 0{,}40) \cdot \sigma(1).$$

Besonders bevorzugt ist es, wenn der Füllgrad $\sigma$(2) im Bereich

$$(1 + 0{,}25) \cdot \sigma(1) > \sigma(2) > (1 - 0{,}25) \cdot \sigma(1)$$

liegt.

Ganz besonders bevorzugt ist es, wenn $\sigma$(2) im Bereich

$$(1 + 0{,}10) \cdot \sigma(1) > \sigma(2) > (1 - 0{,}10) \cdot \sigma(1)$$

liegt.

In einer besonderen Ausgestaltung der Erfindung umfasst in einem Verfahren das erste facettierte katoptrische Element erste Rasterelemente, wobei die ersten Rasterelemente die Feldform des Feldes in der Feldebene aufweisen.

Bei einem erfindungsgemäßen Verfahren wird die Brennweite der zweiten optischen Komponente durch eine Änderung des Abstandes zwischen einer der nachfolgenden optischen Elemente der ersten optischen Komponente oder der zweiten optischen Komponente eingestellt:

- dem Abstand zwischen zweitem facettierten katoptrischen Element und erstem optischen Element;
- dem Abstand zwischen erstem und zweitem optischen Element;
- dem Abstand zwischen zweitem optischen Element und der Feldebene.

Bevorzugt ist es, wenn bei einem erfindungsgemäßen Verfahren das erste facettierte katoptrische Element erste Rasterelemente umfasst, wobei die ersten Rasterelemente eine rechteckige Form aufweisen. Die Rasterelemente sind als reflektive Rasterelemente ausgelegt.

Gemäß einem weiteren Aspekt der Erfindung wird ein Verfahren zum Einstellen einer Ausleuchtung in der Pupillenebene eines katoptrischen Beleuchtungssystems vorgeschlagen, wobei die Ausleuchtung in der Pupillenebene eine Form und eine Größe in der Pupillenebene aufweist, wobei in einem ersten Schritt die Form der Ausleuchtung in der Pupillenebene und daran anschließend in einem zweiten Schritt die Größe der Ausleuchtung in der Pupillenebene eingestellt wird, wobei die Größe der Ausleuchtung in der Pupillenebene durch kontinuierliche Variation eingestellt wird, wobei die Form der Ausleuchtung in der Pupillenebene und die Ausleuchtung des Beleuchtungssystems in der Feldebene weitgehend konstant bleiben.

Eine Projektionsbelichtungsanlage, insbesondere für die Mikrolithographie mit Wellenlängen $\leq$ 193 nm mit einem derartigen Beleuchtungssystem zur Verfügung bildet eine Maske, das so genannte Retikel, das in der Feldebene des Beleuchtungssystems angeordnet ist mit Hilfe eines Projektionsobjektives auf ein lichtsensitives Objekt in einer Objektebene ab.

Wird die lichtempfindliche Schicht nach Ihrer Belichtung entwickelt, so kann eine strukturierte Schicht, beispielsweise eines integrierten Schaltkreises erhalten werden.

Die Erfindung soll nachfolgend anhand der Ausführungsbeispiele ohne Beschränkung hierauf und die Figuren beschrieben werden.

Sämtlich zuvor genannten Einzelmaßnahmen können miteinander kombiniert werden, ohne, dass von der Erfindung abgewichen wird, wie sie in den Ansprüchen definiert ist.

Es zeigen:

| | |
|---|---|
| Fig. 1 a: | allgemeiner Aufbau einer Mikrolithographie-Belichtungsanlage |
| Fig. 1 b: | die Definition der objektseitigen numerischen Apertur NA |
| Fig. 1c: | die Definition der Einfallswinkel auf eine Spiegeloberfläche |
| Fig. 1 d: | ein Feld in der Objektebene |
| Fig. 1 e: | eine Ansicht einer Projektionsbelichtungsanlage mit den einzelnen optischen Elementen |
| Fig. 2: | ein erstes facettiertes optisches Element mit Feldfacetten |
| Fig. 3: | ein zweites facettiertes optisches Element mit Pupillenfacetten |
| Fig. 4-5: | unterschiedliche Ausleuchtungen in einer Pupillenebene des Beleuchtungssystems |
| Fig. 6: | Anordnung der Pupillenfacetten in zwei Positionen mit im wesentlichen gleichen Abstand zu den sekundären Lichtquellen |
| Fig. 7: | eine erste Ausführungsform eines erfindungsgemäßen Systems mit feldformenden Spiegeln |
| Fig. 8: | eine zweite Ausführungsform eines erfindungsgemäßen Systems mit bogenförmigen Feldfacetten |
| Fig. 9 a - c: | Ausführungsbeispiele bei denen durch Variation der Abstände von Feldfacettenspiegel zu Pupillenfacettenspiegel die Ausleuchtung und damit das Setting in der Pupille geändert wird. |

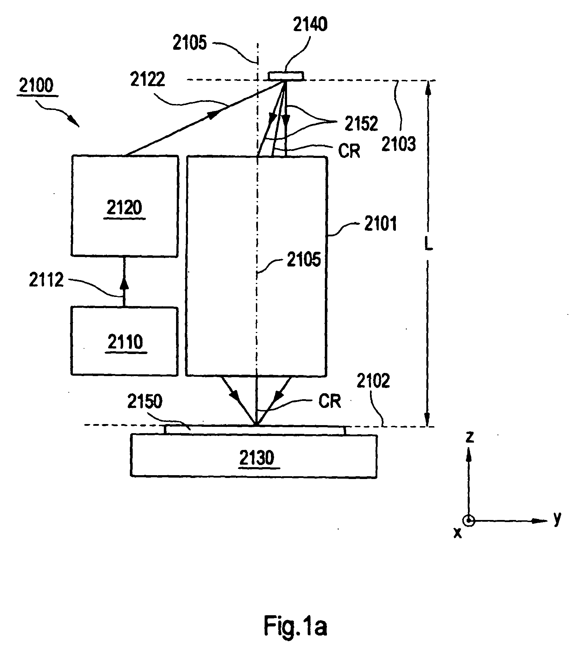

In den Figuren 1a bis 1d sind allgemeine Begriffe, die in einer Vielzahl von Ausführungsbeispielen verwendet werden und sich auf eine Vielzahl von Ausführungsbeispielen beziehen, detailliert anhand der Figuren beschrieben.

In Figur 1a ist der allgemeine Aufbau einer Mikrolithographie-Projektionsbelichtungsanlage 2100 gezeigt. Die Mikrolithographie-Projektionsbelichtungsanlage umfasst eine Lichtquelle 2110, ein Beleuchtungssystem 2120, ein Projektionsobjektiv 2101 sowie eine Trägerstruktur bzw. Arbeitsfläche 2130. Des Weiteren ist ein karthesisches x,y,z-Koordinatensystem dargestellt. Die Strahlung der Lichtquelle 2110 wird einem Beleuchtungssystem 2120 zugeführt. Das Beleuchtungssystem 2120 beeinflusst die von der Lichtquelle 2110 ausgehende Strahlung, bspw. in dem die Strahlung homogenisiert wird oder indem ein Strahlbündel 2122 der Strahlung auf eine Maske 2140, die in einer Objektebene 2103 positioniert ist, gelenkt wird. Das Projektionsobjektiv 2101 bildet die von der Maske 2140 reflektierte Strahlung auf eine Substratoberfläche 2150, die in einer Bildebene 2102 positioniert ist ab. Das Strahlbüschel auf der Bildseite des Projektionsobjektives 2101 ist mit Bezugsziffer 2152 gekennzeichnet. Das Substrat 2150 wird von einer Trägerstruktur 2130 unterstützt bzw. getragen, wobei die Trägerstruktur 2130 das Substrat 2150 relativ zum Projektionsobjektiv 2101 bewegt, so dass das Projektionsobjektiv 2101 die Maske 2140 auf unterschiedliche Bereiche des Substrats 2150 abbildet.

Das Projektionsobjektiv 2101 umfasst eine optische Achse 2105. Die einzelnen optischen Elemente des Projektionsobjektives sind um die optische Achse 2105 rotationssymmetrisch angeordnet. Die Ebene die die optische Achse 2105 enthält ist die Meridonalebene des Projektionsobjektives. Wie in Figur 1a dargestellt bildet das Projektionsobjektiv 2101 ein Teil der Maske 2140 der nicht die optische Achse 2105 des Projektionsobjektives 2101 umfasst in eine Bildebene 2102 ab. In nicht dargestellten alternativen Ausgestaltungen können auch Objekte, die auf der optischen Achse 2105 des Projektionsobjektives liegen in die Bildebene 2102 abgebildet werden. Die Lichtquelle 2110 wird derart ausgewählt, dass sie elektromagnetische Strahlung bei einer Betriebswellenlänge λ, mit der die Mikrolithographie-Projektionsbelichtungsanlage 2100 betrieben wird, zur Verfügung stellt. In einigen Ausführungsbeispielen ist die Lichtquelle 2110 eine Plasmaquelle wie bspw. eine Laserplasmaquelle für die Emission von EUV-Strahlung im Wellenlängenbereich 9 - 14 nm oder ein ArF-Laser bei 193 nm.

Die Betriebswellenlänge λ der Mikrolithographie-Projektionsbelichtungsanlage liegt bevorzugt im ultraviolettem oder extremen ultravioletten (EUV)-Bereich des elektromagnetischen Spektrums. Die Betriebswellenlänge kann insbesondere 193 nm oder weniger, ganz besonders 100 nm oder weniger, betragen. In den Ausführungsbeispiel kann die Betriebswellenlänge ganz besonders bevorzugt im EUV-Wellenlängenbereich, insbesondere im Bereich um 13 nm, liegen.

Die Verwendung von besonders kurzwelliger Strahlung ist besonders wünschenswert, da im Allgemeinen die Auflösung eines Projektionsobjektives, das in einer Projektionsbelichtungsanlage eingesetzt wird, in etwa proportional zur verwendeten Betriebswellenlänge ist. Deswegen können bei Verwendung kürzerer Wellenlängen, Projektionsobjektive kleinere Strukturen eines Bildes als gleichartige Projektionsobjektive, die längere Wellenlängen benutzen, auflösen.

Das Beleuchtungssystem 2120 umfasst optische Komponenten, die einen kollimierten Strahl mit einem weitgehenden homogenen Intensitätsprofil zur Verfügung stellen. Das Beleuchtsystem 2120 umfasst des Weiteren Optiken um das Strahlbüschels 2122 auf die Maske 2140 zu lenken. In einer besonders bevorzugten Ausführungsform umfasst das Beleuchtungssystem 2120 des Weiteren Komponenten, die ein bestimmtes Polarisationsprofil des Strahlbüschels zur Verfügung stellen. Jeder optischen Komponente des Beleuchtungssystems ist ein lokales x,y,z-Koordinatensystem zugeordnet, das durch Translation und Rotation aus einem x,y,z-Koordinatensystem das in der Objektebene 2103 zu einem zentralen Feldpunkt definiert ist, hervorgeht. Die Meridonalebene eines optischen Elementes im Beleuchtungssystem ist die Reflektionsebene des Haupstrahles CR. Die Reflektionsebene wird zum Beispiel durch die lokale z-Achse und den Haupstrahl CR zum zentralen Feldpunkt gebildet. Hierbei ist die lokale z-Achse des jeweiligen optischen Elementes definiert als die Flächennormale im Auftreffpunkt des Haupstrahles CR.

Die Bildebene 2102 weist zur Objektebene 2103 einen Abstand L auf, der auch als Baulänge des Projektionsobjektives 2101 bezeichnet wird. Im Allgemeinen hängt diese Baulänge von der spezifischen Ausgestaltung des Projektionsobjektives 2101 und der Wellenlänge, mit der die Mikrolithographie-Projektionsbelichtungsanlage 2100 betrieben wird, ab. In den beschriebenen Ausführungsbeispielen liegt die Baulänge im Bereich von einem Meter bis ungefähr drei Meter, bevorzugt im Bereich von ungefähr 1,5 m bis 2,5 m.

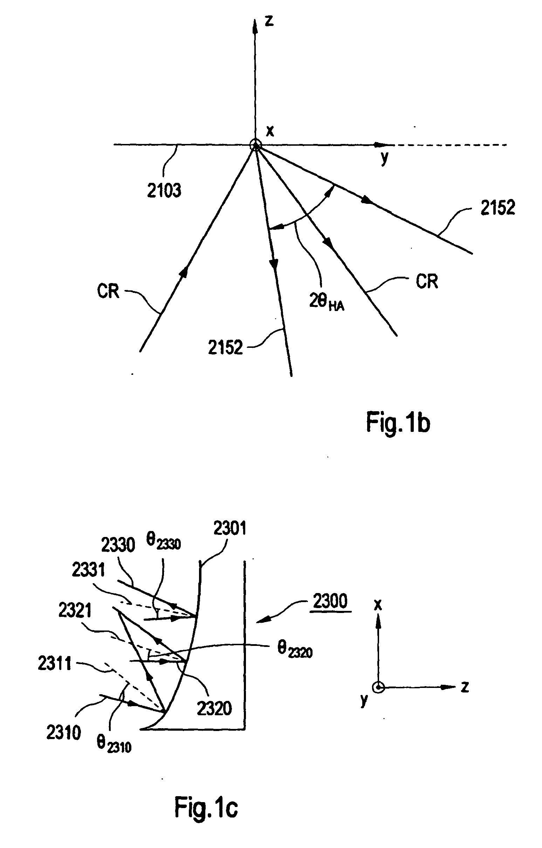

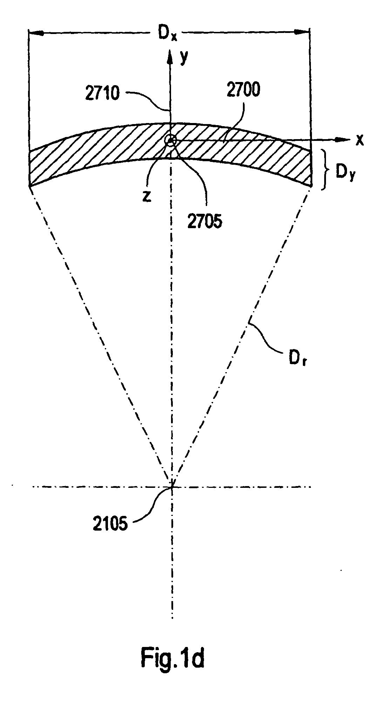

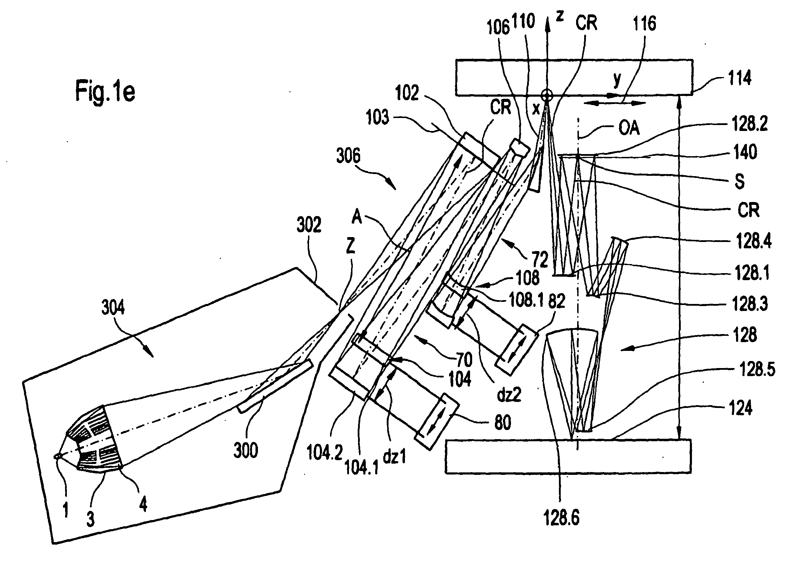

In Figur 1 b sind die Randstrahlen 2152 des Lichtbüschels die am Objekt in der Objektebene 2103 reflektiert und in die Bildebene 2102 abgebildet werden dargestellt. Die Randstrahlen 2152 definieren einen Strahlkonus.

Der Winkel des Strahlenkonus steht in Beziehung zur objektseitigen numerischen Apertur NA der Austrittspupille des Beleuchtungssystems, die gleichzeitig auch die Eintrittspupille des Projektionsobjektives ist. Die objektseitige numerische Apertur kann ausdrückt werden als

$$NA = n_0 * \sin\Theta_{NA},$$

wobei $n_0$ sich auf den Brechungsindex des Mediums bezieht, der der Objektebene 2103 benachbart ist. Dieses Medium kann bspw. Luft, Stickstoff, Wasser oder Vakuum sein. $2\Theta_{NA}$ ist der Winkel, der durch die Randstrahlen definiert wird. Handelt es sich insbesondere um ein Beleuchtungssystem mit EUV Licht, so ist das Medium Vakuum mit dem Brechungsindex $n_0 = 1$.

Im Allgemeinen variiert der Anteil der Strahlung, der von einem Spiegel reflektiert wird, als Funktion des Einfallswinkels der Strahlung auf die Spiegeloberfläche. Da die abbildende Strahlung durch ein katoptrisches System entlang einer Vielzahl von unterschiedlichen Wegen propagiert, kann der Einfallswinkel der Strahlung auf jedem Spiegel variieren. Dies ist gezeigt in Figur 1c, die einen Teil eines Spiegels 2300 im meridionalen Schnitt, das heißt in der Meridionalebene des Spiegels zeigt. Die Meridionalebene ist die Ebene des optischen Elementes, die die lokale z-Achse des jeweiligen optischen Elementes sowie den Haupstrahl CR zu dem zentralen Feldpunkt des beispielsweise in Figur 1 d gezeigten Feldes umfasst. Das lokale Koordinatensystem ist in Figur 1c angegeben. Der Spiegel 2300 umfasst eine konkave reflektive Spiegeloberfläche 2301. Die abbildende Strahlung, die auf die Fläche 2301 entlang unterschiedlicher Wege auftrifft, umfasst bspw. die Wege, die durch die Strahlen 2310, 2320, 2330 dargestellt sind. Die Strahlen 2310, 2320 und 2330 treffen auf einen Teil der Spiegeloberfläche 2301 auf. Die Normalen auf die Oberfläche des Spiegels sind in diesem Bereich der Spiegeloberfläche 2301 unterschiedlich. Die Richtung der Oberflächennormalen sind in diesem Bereich durch die Geraden 2311, 2321 und 2331, die korrespondierend zu den Strahlen 2310, 2320 und 2330 sind, dargestellt. Die Strahlen 2310, 2320, und 2330 treffen auf die Oberfläche unter den Winkeln $\Theta_{2310}$, $\Theta_{2320}$ und $\Theta_{2330}$ auf. Die Geraden 2311, 2321, 2331 liegen alle in der durch die z-Achse des lokalen Koordinatensystems und den Hauptstrahl CR (nicht gezeigt) definierten Meridonalebene.

Für jedes Element des Beleuchtungssystems 2120 bzw. Projektionsobjektives 2100 können die Einfallswinkel der Strahlen auf eine Vielzahl von Wegen dargestellt werden. Eine mögliche Darstellung ist der maximale Winkel der auf jeden Spiegel auftreffenden Strahlen in der Meridonalebene des jeweiligen Elementes. Dieser maximale Winkel wird mit $\Theta_{max}$ bezeichnet. Im Allgemeinen kann der Winkel $\Theta_{max}$ verschiedener Spiegel des Beleuchtungssystemes bzw. des Projektionsobjektives 2101 variieren. In bestimmten Ausführungsbeispielen der Erfindung beträgt der maximale Wert $\Theta_{max(max)}$ für alle Spiegel des Beleuchtungssystemes bzw. Projektionsobjektives, bevorzugt 20° oder weniger, insbesondere 15° oder weniger, insbesondere 13° oder weniger, besonders bevorzugt 10° oder weniger, betragen.

Generell unterscheidet man bei reflektiven Systemen zwischen sog. normal-incidence-Elementen und grazing-incidence-Elementen. Normal-incidence-Elemente sind solche Elemente bei denen die Einfallswinkel aller auf das Element auftreffenden Strahlen in Bezug zur Normalen am Auftreffpunkt < 30°, bevorzugt < 20°, ganz bevorzugt < 10°, insbesondere bevorzugt < 5° ist. Grazing-incidence-Elemente sind solche Elemente, bei denen die Einfallswinkel aller auf das Element auftreffenden Strahlen in Bezug zur Normalen am Auftreffpunkt ≥ 70° sind. Im Allgemeinen kann die Form des Feldes das in der Objektebene 2103 des Beleuchtungssystemes ausgebildet wird, variieren. In einigen Ausführungsbeispielen kann das Feld eine bogenförmige Form aufweisen bspw. die Form eines Segmentes eines Ringes, ein so genanntes Ringfeld. In Figur 1d ist ein Ringsegment 2700 bzw. Ringfeld dargestellt. Dieses Ringsegment 2700 kann durch eine x-Dimension $D_x$, eine y-Dimension $D_y$ und eine radiale Dimension $D_r$ charakterisiert werden. $D_x$ und $D_y$ korrespondieren zur Dimension des Feldes bzw. zur Abmessung des Feldes entlang der x-Richtung und der y-Richtung des lokalen Koordinatensystems in der Bildebene 2102 bzw. Objektebene 2103. Diese Größen werden in der nachfolgenden Beschreibung angegeben. So beträgt bei einem Feld mit einer von bspw. 18·1 mm$^2$ in der Bildebene $D_x=18$ mm und $D_y=1$ mm. $D_r$ korrespondiert zum Ringradius gemessen von der optischen Achse 2105 zur inneren Grenze des Feldes 2700. Das Ringfeldsegment 2700 ist symmetrisch bezogen auf die Ebene parallel zur y-z-Ebene, wie durch die Linie 2710 angedeutet. Im Allgemeinen ist die Größe von $D_x$, $D_y$ und $D_r$ variabel und hängt von dem Design des Beleuchtungssystems bzw. des Projektionsobjektives 2101 ab. Typischerweise ist $D_x$ größer als $D_y$. Die relative Größe der Felddimensionen bzw. Feldabmessungen $D_x$, $D_y$ und $D_r$ in der Objektebene 2103 und der Bildebene 2102 variieren in Abhängigkeit von der Vergrößerung oder Verkleinerung des Projektionsobjektives 2101 der Projektinsbelichtungsanlage. In einigen Ausführungsbeispielen ist $D_x$ in der Objektebene 2103 relativ groß.

Allgemein gesprochen kann für beliebige Feldformen eine maximale Felddimension bzw. Feldabmessung in der Bildebene 2102, beispielsweise $D_x$ für ein Ringfeld, mehr als 1 mm, insbesondere mehr als 3 mm, bevorzugt mehr als 4 mm, insbesondere mehr als 5 mm, bevorzugt mehr als 6 mm, insbesondere mehr als 7 mm, bevorzugt mehr als 8 mm, insbesondere mehr als 9 mm, bevorzugt mehr als 10 mm, insbesondere mehr als 11 mm, bevorzugt mehr als 12 mm, insbesondere mehr als 13 mm, bevorzugt mehr als 14 mm, insbesondere mehr als 15 mm, bevorzugt mehr als 18 mm, insbesondere mehr als 20 mm oder mehr als 25 mm betragen. Die andere Felddimension, beispielsweise $D_y$ für ein Ringfeld, kann im Bereich 0,5 mm bis 10 mm liegen. Bevorzugt werden mit dem erfindungsgemäßen Beleuchtungssystem Flächen mit einer Fläche $F > 4$ mm$^2$, bevorzugt $> 10$ mm$^2$, ganz bevorzugt $> 20$ mm$^2$, insbesondere $> 25$ mm$^2$ in der Bildebene ausgeleuchtet. Für ein Rechteckfeld ergibt sicht die Fläche $F=D_x \cdot D_y$.

Bei einem Ringfeld kann der Ringfeldradius $D_r$ größer 15mm oder mehr in der Bildebene 2102 betragen.

Ist das Projektionsobjektiv ein verkleinerndes Projektionsobjektiv, bspw. mit einer Verkleinerung von 4x, so hat das Objektfeld eine Dimension von 4mm x 100 mm, wenn das Bildfeld eine Dimension von 1 mm x 25 mm aufweist. Bei bekannter Verkleinerung des Projektionsobjektives, die bevorzugt bei 4x, insbesondere 5x liegt, ist durch die Dimension des Bildfeldes für den Fachmann, die Dimension des Objektfeldes gegeben.

Bei dem Ringfeldsegment 2700 bezeichnet die y-Richtung des Koordinatensystems die sog. Scanrichtung falls das Beleuchtungssystem in einem Scanning-Mikrolithographie-Projektionssystem wie in Fig. 1e dargestellt eingesetzt wird und x-Richtung die Richtung, die senkrecht auf der Scan-Richtung steht. In Abhängigkeit von der x-Position, die auch als sog. Feldhöhe bezeichnet wird, können scanintegrierte Größen, d. h. Größe die entlang der y-Achse integriert werden, bestimmt werden. Viele Größen einer Beleuchtung sind feldabhängige Größen. Eine derartige feldabhängige Größe ist bspw. die sog. Scanning-Energie (SE), deren Größe je nach Feldhöhe x unterschiedlich ausfällt, d. h. die Scanning-Energie ist eine Funktion der Feldhöhe. Generell gilt

$$SE(x) = \int E(x,y)dy,$$

wobei

E die Intensitätsverteilung in der x-y-Feldebene abhängig von x und y ist. Für eine uniforme, d.h. gleichmäßige Ausleuchtung und andere charakteristische Größen des Beleuchtungssystemes wie die Elliptizität und die Telezentrie die gleichfalls von der Feldhöhe x abhängen, ist es von Vorteil, wenn diese Größen im Wesentlichen über der gesamten Feldhöhe x einen im Wesentlichen gleichen Wert aufweisen und nur geringe Abweichungen auftreten.

In Figur 1e ist in einer Ansicht einer Projektionsbelichtungsanlage für die Herstellung von beispielsweise mikroelektronischen Bauteilen, bei der die Erfindung zur Anwendung kommen kann, gezeigt, wobei die einzelnen Elemente des Beleuchtungssystem und des Projektionsobjektives dargestellt sind. Bei dem dargestellten System handelt es sich um ein katoptrisches System mit katoptrischem Beleuchtungssystem 306 und katoptrischen Projktionsobjektiv 128. Da es sich bei dem dargestellten System um ein katoptrisches System handelt, sind alle optischen Komponenten bzw. Elemente reflektiv bspw. als Spiegel bzw. Spiegelelemente ausgebildet.

Die beispielhafte Projektionsbelichtungsanlage umfasst eine Lichtquelle oder ein Zwischenbild Z einer Lichtquelle 1. Das von der Lichtquelle 1 ausgesandte Licht wird von einem Kollektor 3 umfassend eine Vielzahl von Spiegelschalen gesammelt. Auf den Kollektor folgt bei der gezeigten Projektionsbelichtungsanlage ein weiteres optisches Element, das vorliegend als Planspiegel 300 ausgebildet ist. Die vom Kollektor auf den Planspiegel 300 auftreffenden Strahlen werden umgelenkt, insbesondere um Bauraum für die mechanischen und optischen Komponenten in einer Objektebene 114, in der die Waferstage angeordnet ist, zur Verfügung zu stellen. Des Weiteren gezeigt ist in der Objektebene das x,y,z-Koordinatensystem. In der Objektebene 114 kann eine Maske, d.h. ein Retikel (nicht dargestellt) angeordnet sein, das mit Hilfe des Projektionsobjektives 128 in eine Bildebene 124 abgebildet wird. Der Planspiegel 300 kann auch als diffraktives Spektralfilterelement ausgelegt werden. Ein derartig diffraktives Spektralfilterelement ist beispielsweise ein Gitter, wie in der US-2002-0186811 A1 offenbart. Zusammen mit einer Blende 302 in der Nähe des Zwischenbildes Z der Lichtquelle 1, kann mit einem derartigen Gitterelement in erwünschte Strahlung mit beispielsweise Wellenlängen wesentlich größer als der gewünschte Wellenlänge vom Eintritt in den Teil des hinter der Blende 302 liegenden Beleuchtungssystems 300 abgehalten werden.

Die Blende 302 kann auch dazu dienen, den Raum 304 umfassend die Lichtquelle sowie den Kollektor 3 und den als Gitter ausgelegten Planspiegel 300 vom nachfolgenden Teil des Beleuchtungssystem 306 räumlich zu trennen. Werden beide Räume durch das Einbringen eines Ventils nahe des Zwischenfokus Z getrennt, so ist auch eine druckmäßige Trennung möglich. Durch eine räumliche bzw. eine durckmäßige Trennung kann verhindert werden, dass Verschmutzungen, die von der Lichtquelle 1 herrühren in das hinter der Blende 302 liegendem Beleuchtungssystem gelangen

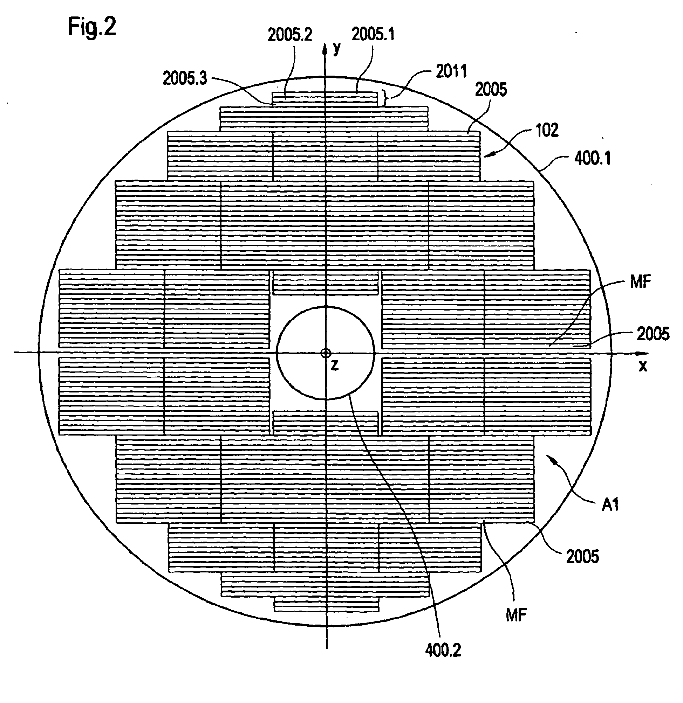

Das von dem Kollektor 3 gesammelte und über den Planspiegel 300 umgelenkte Licht wird auf die erste optische Komponente 70 des Beleuchtungssystemes gelenkt. Die erste optische Komponente 70 umfasst ein erstes facettiertes optisches Element 102 und ein zweites facettiertes optisches Element 104. Das erste facettierte optische Element 102 ist vorliegend ein facettiertes katoptrisches Element, bspw. ein Spiegel mit einer Vielzahl von ersten katoptrischen Rasterelementen, sog. Feldfacettenspiegeln. Der Aufbau eines derartigen ersten facettierten optischen Elementes ist in Figur 2 gezeigt.

Im vorliegenden Fall sind die ersten Rasterelemente im Wesentlichen von rechteckiger Form und des einzelnen Spiegelfacetten ausgebildet. Damit sekundäre Bilder der Lichtquelle in oder nahe der Pupillenfacetten des zweiten optischen Elementes 104 ausgebildet werden, wie in Figur 2 gezeigt weisen die ersten Rasterelemente, die auch als Feldfacetten bezeichnet werden, eine positive Brechkraft auf. Die Ausleuchtung in der Ebene in der das erste facettierte optische Element 102 angeordnet ist, ist im Wesentlichen kreisförmig, wobei durch jede Spiegelschale des Kollektors je ein kreisförmiger Bereich ausgeleuchtet wird, die in der Ebene 103 im Wesentlichen direkt aneinander anschließen. Eine derartige Ausleuchtung ist für einen Kollektor bspw. in der US-2003-0043455A1 beschrieben.

Die erste optische Komponente 70 des Beleuchtungssystems 306 umfasst neben dem ersten facettierten optischen Element 102 ein zweites facettiertes optisches Element 104 mit zweiten Rasterelementen, sogenannten Pupillenfacetten. In Figur 2 ist das zweite facettierte optische Element in zwei Positionen 104.1, 104.2 gezeigt. Das zweite facettierte optische Element ist ein zweites facettiertes katoptrisches Element bspw. ein Spiegel mit einer Vielzahl von zweiten katoptrischen Rasterelementen sog. Pupillenfacettenspiegeln.

Das von der Lichtquelle her einfallende Licht wird durch das erste facettierte optische Element 102 mit Feldfacetten in mehrere Lichtbüschel (nicht dargestellt) zerlegt. Die einzelnen den jeweiligen Feldfacetten zugeordneten Lichtbüschel treffen auf je eine Pupillenfacette. Jeder Feldfacette des ersten facettierten optischen Elementes ist somit ein Pupillenfacette des zweiten facettierten optischen Elements zugeordnet. Diese Zuordnung kann, wie in der US 2002-0136351 A1 bzw. US 6,658,084 gezeigt, die Form der Ausleuchtung, d.h. das Beleuchtungssettings in der Austrittspupille des Beleuchtungssystems bestimmen. Die Ausleuchtung bzw. das Beleuchtungssetting in der Austrittspupille kann konventionell (d.h. gefüllter Kreis), annular (d. h. geschlossener Kreisring), dipolförmig (zwei sich gegenüberliegende Flecken) oder quadrupolförmig (vier Flecken um 90° verschoben) sein.

Die Austrittspupille des Beleuchtungssystems ist im Regelfall durch den Schnittpunkt S des Hauptstrahls CR zum zentralen Feldpunkt im auszuleuchtenden Feld in der Feldebene 114 mit der optischen Achse OA eines Projektionsobjektives gegeben, das in einer Projektionsbelichtungsanlage dem Beleuchtungssystem im Lichtweg nachgeordnet ist. Für ein derartiges System fällt die Austrittspupille des Beleuchtungssystems mit der Eintrittspupille des Projektionsobjektives zusammen. Diese Austrittspupille ist im vorliegenden Ausführungsbeispiel mit der Bezugsziffer 140 gekennzeichnet.

Bei dem gezeigten Beleuchtungssystem kann der Abstand A zwischen dem ersten facettierten optischen Element 102 und der zweiten facettierten optischen Element 104 variiert werden. Der Abstand A ist gegeben durch die Länge des Lichtweges entlang des Hauptstrahles CR zum zentralen Feldpunkt in der Feldebene von dem ersten facettierten optischen Element 102 zum zweiten facettierten optischen Element 104. In vorliegendem Ausführungsbeispiel wird der Abstand A durch ein Verschieben des zweiten facettierten optischen Elementes 104 beispielsweise mit Hilfe einer ersten Einstelleinrichtung 80 um den Abstand dz1 erreicht. Das erste facettierte optische Element 102 bleibt hierbei ortsfest. Dies ist vorteilhaft aber keineswegs zwingend. Das erste facettierte optische Element 102 kann im konvergenten, divergenten oder parallelen Strahlengang angeordnet sein. Vorliegend ist das erste facettierte optische Element 102 im divergenten Strahlengang angeordnet. Nach dem ersten facettierten optischen Element 102 liegt zwischen erstem facettierten optischen Element 102 und zweitem facettierten optischen Element 104 ein Strahlengang vor, bei dem alle Schwerpunktstrahlen der Strahlbüschel, die von den einzelnen Feldfacetten des ersten facettierten optischen Elementes 102 ausgehen parallel zueinander verlaufen, so dass auch bei einer Verschiebung des zweiten facettierten optischen Elementes 104 aus einer ersten Position 104.1 in eine zweite Position 104.2 die den jeweiligen Feldfacetten des ersten facettierten optischen Elementes 102 zugeordneten Pupillenfacetten des zweiten facettierten optischen Elementes 104 von den Strahlbüscheln getroffen werden. Durch die Änderung des Abstandes von erstem facettierten optischen Element 102 und zweitem facettierten optischen Element 104 wird lediglich die Feldabbildung beeinflusst, die Pupillenabbildung bleibt unbeeinflusst, d.h. durch das Verschieben kann die Pupillenabbildung nicht verändert werden.

Die zweite optische Komponente umfasst in vorliegendem Ausführungsbeispiel drei optische Elemente, ein erstes optische Element 106, ein zweites optisches Element 108 und ein drittes optisches Element 110. Bei dem dargestellten Beleuchtungssystem dient das dritte optische Element 110 im Wesentlichen dazu, das Feld in der Objektebene 114 zu formen. Das Feld in der Objektebene 114 ist im Regelfall ein Kreisbogensegment wie in Fig. 1 d gezeigt. Die Brennweite der zweiten optischen Komponente 72 wird durch die optische Wirkung und die Abstände von

- zweitem facettierten optischen Element 104 der ersten Komponente zu erstem optischen Element 106;
- erstem optischen Element 106 zu zweitem optischen Element 108;
- zweitem optischen Element 108 zu drittem optischen Element 110 und
- drittem optischen Element zu Objektebene 114

bestimmt. Daher ist es möglich durch Veränderung mit Hilfe einer zweite Einstelleinrichtung 82 einer der oben genannten Abstände die Brennweite der zweiten optischen Komponente bspw. durch Verfahren des zweiten optischen Elementes um dz2, zu verändern. Wird die Brennweite der zweiten optischen Komponente verändert, so ändert sich sowohl die Feld- wie die Pupillenabbildung. Die Änderung der Feldabbildung kann wie oben beschrieben durch eine Abstandsänderung von erstem facettiertem optischen Element zu zweitem facettierten optischen Element kompensiert werden, so dass das auszuleuchtende Feld in Form und insbesondere Beleuchtungsstärke weitgehend unbeeinflusst, d.h. invariant bleibt, während sich die Pupillenabbildung ändert. Bevorzugt wird auch bei der zweiten optischen Komponente nur ein Element, in vorliegendem Fall das zweite optische Element um dz2 mit Hilfe einer zweiten Einstelleinrichtung 82 verfahren. Dann ergeben sich zwei Stellungen 108.1 und 108.2 für das zweite optische Element.

In der Objektebene 114 ist eine nicht dargestellte Maske bzw. Retikel angeordnet, das mit Hilfe der Beleuchtungsvorrichtung ausgeleuchtet und mit Hilfe des Projektionsobjektives 128 in eine Bildebene 124 abgebildet wird. In einem Scanning-System ist das in der Objektebene 114 angeordnete Retikel in der Scan-Richtung 116, die mit der y-Richtung zusammenfällt, verfahrbar. Die Austrittspupille des Beleuchtungssystems fällt mit der Eintrittspupille des Projektionsobjektives 128 zusammen.

Das Projektionsobjektiv 128 weist in der dargestellten Ausführungsform sechs Spiegel 128.1, 128.2, 128.3, 128.4, 128.5 sowie 128.6 auf und ist beispielsweise wie im US-Patent US 6,600,552 B2 ausgebildet.

Das Projektionsobjektiv 128 bildet das in der Objektebene 114 befindliche, nicht dargestellte, Retikel in die Bildebene 124 ab.

In Figur 2 ist das erste facettierte optischen Elementes 102 aus Figur 1 dargestellt. Der insgesamt durch den Kollektor 3 gemäß Figur 1 ausgeleuchtete Bereich A1 ist durch ein von der äußersten Spiegelschale herrührende Begrenzung 400.1 und eine von dem innersten Aperturelement herrührende innere Begrenzung 400.2 definiert.

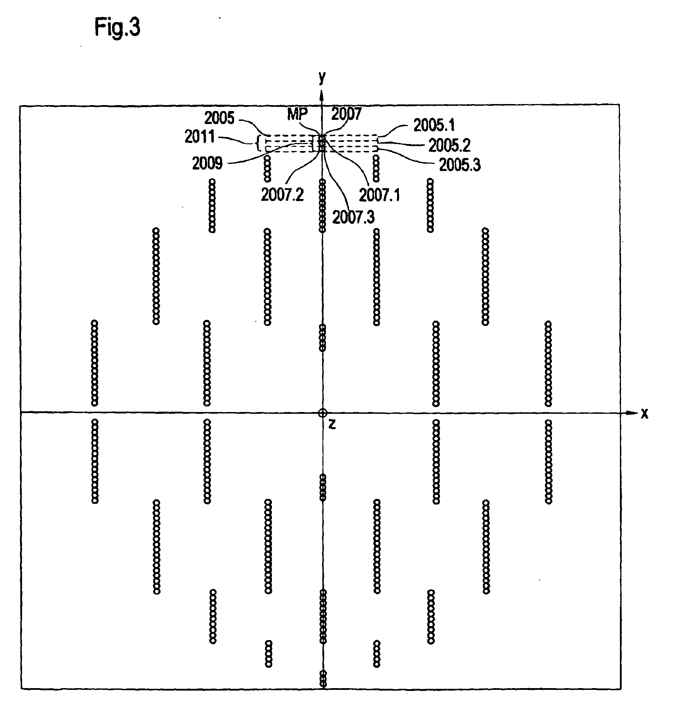

Die Ausleuchtung der Feldfacettenebene in dem dargestellten Ausführungsbeispiel ist, durch den Kollektor 3 bedingt, annular. Des Weiteren zu erkennen sind die reflektiv ausgebildeten Feldfacetten 2005 des ersten facettierten optischen Elementes 102 in Figur 1 e. Die einzelnen Feldfacetten 2005 sind vorliegend Spiegelelemente die auf einem Träger (nicht gezeigt) angeordnet sind. Die Feldfacetten 2005 weisen bei der vorliegenden Ausführungsform mit einem feldformenden Spiegel im Wesentlichen eine rechteckige Form auf. Des Weiteren eingezeichnet ist die Mitte MF einer Feldfacette, von der ein Schwerpunktstrahl (nicht gezeigt), ausgeht, der zur Mitte MP einer in Figur 3 gezeigten Pupillenfacette verläuft.

In Fig. 3 wird eine Anordnung von zweiten Rastelementen, d.h. Pupillenfacetten 2007 auf dem zweiten facettierten optischen Element, das in Figur 1 e mit 104 bezeichnet ist, dargestellt. Die Pupillenfacetten 2007 sind in dem gezeigten Ausführungsbeispiel so angeordnet, dass die Schwerpunktstrahlen der einzelnen Strahlbüschel, die von den jeweiligen Feldfacetten zu den jeweiligen Pupillenfacetten verlaufen im Wesentlichen parallel zueinander sind. Die Schwerpunktstrahlen sind die Strahlen, die von der Mitte MF einer in Figur 2 gezeigten Feldfacette 2005 zur Mitte MP einer in Figur 3 gezeigten Pupillenfacette 2007 verlaufen. Dadurch, dass die Schwerpunktstrahlen parallel verlaufen, bleibt die Zuordnung zwischen Feld- und Pupilenfacetten auch nach Verschieben von zum Beispiel der zweiten facettierten Komponente erhalten. Zur Verdeutlichung wie die einzelnen Feldfacetten 2005 des ersten facettierten optischen Elementes den Pupillenfacetten 2007 des zweiten facettierten optischen Elementes zugeordnet sind, sind in Fig. 3 für den ersten Block 2009 bestehend aus den Pupillenfacetten 2007.1, 2007.2, 2007.3 strichpunktiert die zugeordneten Feldfacetten 2005.1, 2005.2, 2005.3 des ersten facettierten optischen Elementes aus Fig. 2 eingezeichnet. Die jeweiligen Feldfacetten werden auch in Fig. 2 mit denselben Bezugsziffern belegt. Wie aus Fig. 3 zu entnehmen fallen die Mitten MP der jeweiligen Pupillenfacetten mit der Mitte MF der jeweiligen Feldfacette zusammen. Dies bedingt, dass die Schwerpunktstrahlen der Strahlbüschel, die von den jeweiligen Feldfacetten 2005 zu den Pupillenfacetten 2007 verlaufen parallel zueinander sind. Des Weiteren ist Fig. 3 zu entnehmen, dass die Anordnung der Pupillenfacetten in Blöcken 2009 im Wesentlichen der Anordnung der Feldfacetten in Blöcken 2011 entspricht. Des Weiteren eingezeichnet ist in Fig. 3 das x-, y-, z-Koordinatensystem. Bevorzugt entspricht die Gestalt der Pupillenfacetten 2007 der Gestalt der sekundären Lichtquellen in der Ebene ,in der das zweite facettierte optische Element mit Pupillenrasterelementen angeordnet ist. Die Pupillenfacetten sowie die Feldfacetten sind bspw. einzelne Spiegel, die auf einer Trägerstruktur angeordnet sind.

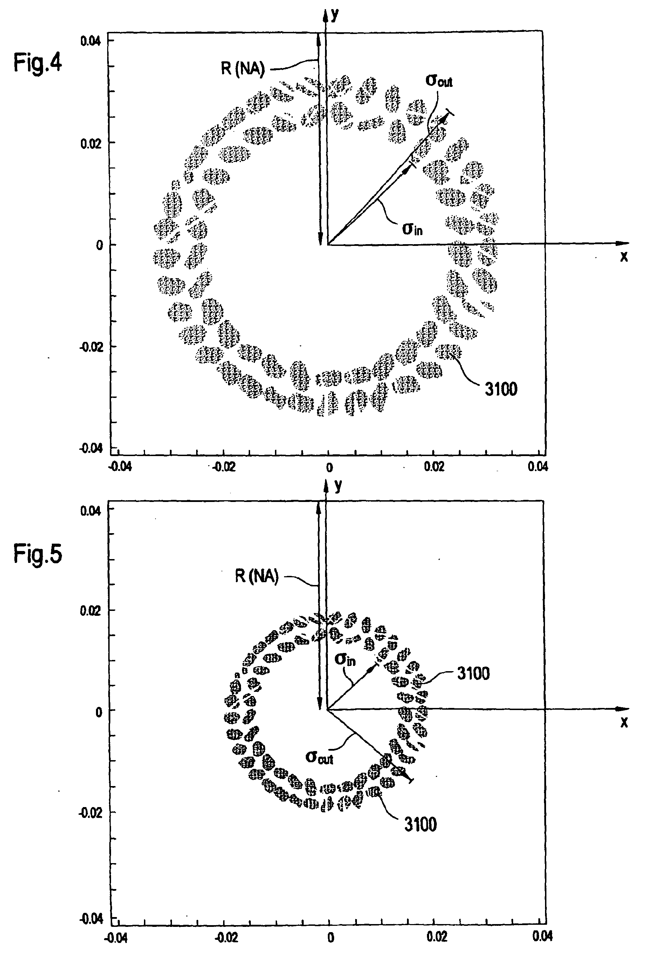

In Figur 4 und 5 dargestellt sind zwei Ausleuchtungen bzw. Beleuchtungssettings der Pupille, wenn das zweite facettierte optische Element der ersten Komponente und das zweite optische Element der zweiten Komponente in zwei unterschiedliche Positionen verbracht werden. Bei der in den Figuren 4 und 5 gezeigten Ausleuchtung bzw. dem Beleuchtungssetting handelt es sich um ein annulares Setting mit einem Füllgrad $\sigma$, der den Grad der Ausleuchtung, d.h. die Größe der Ausleuchtung in der Pupillenebene beschreibt. Die Definintion des Füllgrades $\sigma$ ist für einen Fachmann hinreichend bekannt.

Wie aus den Figuren 4 und 5 hervorgeht unterscheiden sich die beiden Beleuchtungssettings im Wesentlichen im Füllgrad $\sigma$, d.h. im Maß bzw. der Größe der Ausleuchtung, während die Form der Beleuchtungssettings im Wesentlichen identisch, nämlich annular ist.

Wie aus Fig. 4 und 5 zu erkennen, weist die Austrittspupille in der Austrittspupillenebene einzelne Subpupillen, nämlich tertiäre Lichtquellen 3100 auf. Der Unterschied der Ausleuchtung in Figur 4 und 5 ist lediglich ein veränderter Abbildungsmaßstab der einzelnen Subpupillen 3100, da ja lediglich eine Verschiebung und damit eine Maßstabsänderung vorgenommen wird. Die Anzahl der ausgeleucheten Subpupillen 3100 in der Austrittspupille ändert sich hingegen nicht. Insbesondere ist hierdurch die integrale Lichtintensität in der Austrittspupille für beide Beleuchtungssettings weitgehend identisch, d.h. die Beleuchtungsstärke in der Feldebene im Beleuchtungssystem ändert sich durch eine Änderung des Beleuchtungssettings nicht. Sie ist sowohl in einer Feldebene, bspw. der Objektebene des Beleuchtungssystems als auch in einer Pupillenebene bspw. der Austrittspupille des Beleuchtungssystems weitgehend konstant, wenn das Beleuchtungssetting variiert wird. In Figur 4 ist $\sigma_{in}$ und $\sigma_{out}$ für das dargestellte Beleuchtungssetting sowie R(NA) angegeben. In Figur 5 ist $\sigma_{in}$ und $\sigma_{out}$ gezeigt. Die Größen $\sigma_{in}$, $\sigma_{out}$, beschreiben im Wesentlichen die Radien der annularen Ausleuchtung und definieren damit die Größe der annularen Ausleuchtung bzw. den Füllgrad $\sigma$.

Die in Figur 4 gezeigt Ausleuchtung wird erhalten, wenn die zweite facettierte optische Komponente 104 in Figur 1, sowie die zweite optische Komponente 108 in Figur 1 in die ersten Positionen verbracht sind. Wird die zweite facettierte optische Komponente 104 um dz1 verschoben und die zweite optische Komponente 108 um dz2, so ergibt sich die Ausleuchtung wie in Figur 5 gezeigt. Bei einer Verschiebung um dz1 wird die zweite facettierte optische Komponente aus der Position 104.1 in die Position 104.2 verbracht. Wird die zweite optische Komponente 108 um dz2 verschoben, so wird die zweite optische Komponente aus der Position 108.1 in die Position 108.2 verbracht.

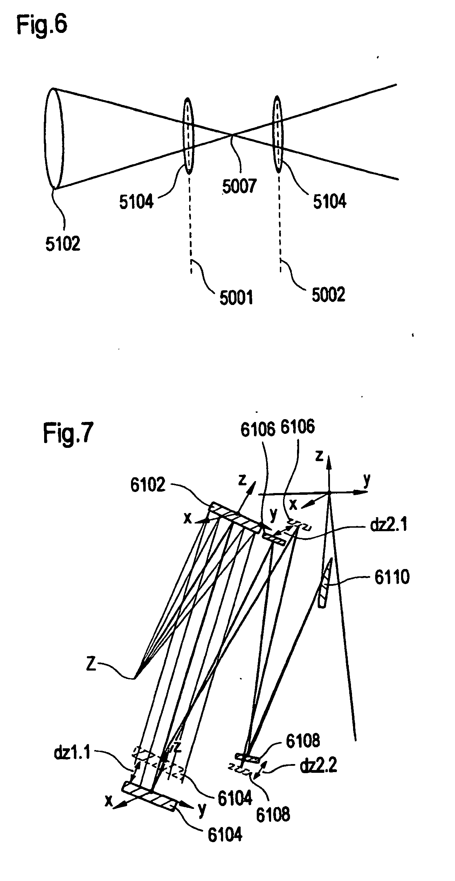

Wenn mit Hilfe des beschriebenen Systems genau zwei Ausleuchtungen, d.h. zwei Beleuchtungssettings mit unterschiedlichem Füllgrad $\sigma$ wie beispielsweise in den Figuren 4 und 5 gezeigt, realisiert werden sollen, ist es vorteilhaft, wenn wie in Figur 6 gezeigt die Brechkraft der Feldfacetten so gewählt wird, dass die sekundären Lichtquellen, die von den Feldfacetten erzeugt werden, im wesentliche in der Mitte zwischen der ersten Position 5001 des zweiten facettierten optischen Elementes 5104 und der zweiten Position 5002 des zweiten facettierten optischen Elementes 5104 zu Liegen kommt. Konsequenz hieraus ist, dass aufgrund der defokussierten Ausleuchtung in der ersten und in der zweiten Position des zweiten facettierten optischen Elementes die Ausleuchtung auf dem zweiten facettierten optischen Element eine elliptische Form hat. Da der Abstand in beiden Positionen zum tatsächlichen sekundären Lichtquellenbild im wesentlichen gleich ist, ist in beiden Stellungen die Form der Ausleuchtung auf dem Pupillenfacettenspiegel gleich. Die einzelnen Pupillenfacetten können dann an die Ausleuchtung angepasst werde, beispielsweise indem die Pupillenfacetten eine elliptische Form aufweisen.

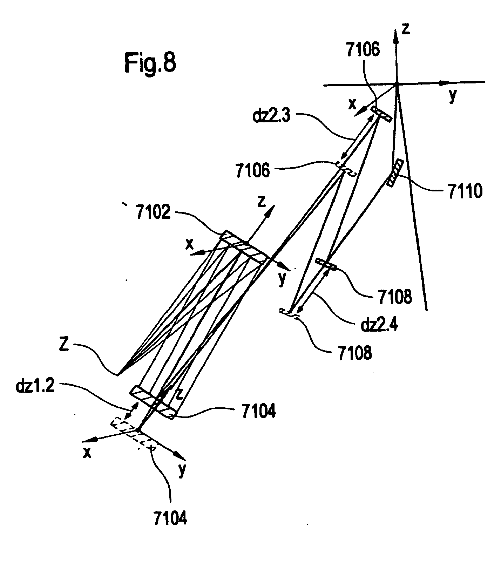

In Figur den Figuren 7 und 8 sind schematisch zwei Beispiele der Erfindung gezeigt, wobei die Systeme ab dem Zwischenbild Z dargestellt sind.

Wie beim in Figur 1 e gezeigten System umfasst auch das System gemäß Figur 7 im Wesentlichen rechteckig ausgebildete Feldfacetten sowie eine dritte optische Komponente 6110 zur Feldformung. Gleiche Bauteile wie im System gemäß Figur 1 sind mit um 6000 erhöhten Bezugsziffern gekennzeichnet. Wie beim System gemäß Figur 1 wird beim System in Figur 7 der Abstand A zwischen erstem facettierten optischen Element 6102 und zweitem facettierten optischen Element 6104 durch Verschieben des zweiten optischen Elementes 6104 um dz1.1 geändert. Zur Brennweiteneinstellung der zweiten optischen Komponente wird das erste optische Element 6106 sowie des zweite optische Element 6108 der zweiten optischen Komponente um einen Weg dz2.1 und dz2.2 verschoben. Wie aus Fig. 7 hervorgeht, werden die optischen Komponenten nicht nur entlang der lokalen optischen Achse, d.h. der z-Richtung des optischen Elementes verschoben, sondern auch schräg dazu im Gegensatz zu refraktiven optischen Elementen. Nur durch ein Schrägverschieben, d. h. ein Verkippen um die lokale optische Achse kann erreicht werden, dass der Ort des Zwischenfokus Z der Lichtquelle seine Position relativ zum Retikel in der Retikelebene 114 nicht verändert und die Lichtquelle damit nicht verfahren werden muss, wenn die optischen Komponenten verfahren werden. In Fig. 7 und 8 sind für die facettierten optischen Elemente 6102, 6104, 7102, 7104 des Beleuchtungssystems die lokalen x,y,z-Koordinatensysteme eingezeichnet, die aus dem x,y,z-Koordinatensystem in der Objektebene durch Translation in der z,y-Ebene und anschließende Rotation der x,y-Ebene um einen Winkel $\gamma$ um die lokale x-Achse des optischen Elementes hervorgeht.

Beim System gemäß Figur 8 weisen die Feldfacetten die Form des Feldes auf und sind im Wesentlichen bogenförmig. Wie aus Figur 8 zu ersehen ist das dritte optische Element 7110 der zweiten optischen Komponente ein Planspiegel, da eine Feldformung nicht vorgenommen werden muß. Im Gegensatz zu dem System gemäß Figur 7 wird eine Änderung der Brennweite der zweiten optischen Komponente dadurch vorgenommen, dass die erste optische Komponente 7106 und die zweite optische Komponente 7108 entlang der Richtung eines Haupstrahles CR zum zentralen Feldpunkt um die Wege dz2.3 und dz2.4 verschoben werden. Des Weiteren wird der Abstand zwischen erster facettierter optischer Komponente 7102 und zweiter facettierter optischer Komponente 7104 durch Verschieben der zweiten facettierten optischen Komponente um dz1.2 verändert. Bei der Feldformung mit Hilfe eines grazing incidence Spiegels wie in Fig. 6 tritt das Problem auf, dass dieser Spiegel nicht in einer Feldebene steht, sondern ca. 300-400mm davor. Aus diesem Grund beeinträchtigt der Spiegel zusätzlich die Pupilleneigenschaften und liefert außerdem leicht unterschiedliche Feldformen. Strahlen, die von zwei verschiedenen Pupillenfacetten kommen, treffen an verschiedenen Orten und unter unterschiedlichen Winkeln auf den feldformenden Spiegel. Damit ergeben sich leicht unterschiedliche Formen des Feldes.

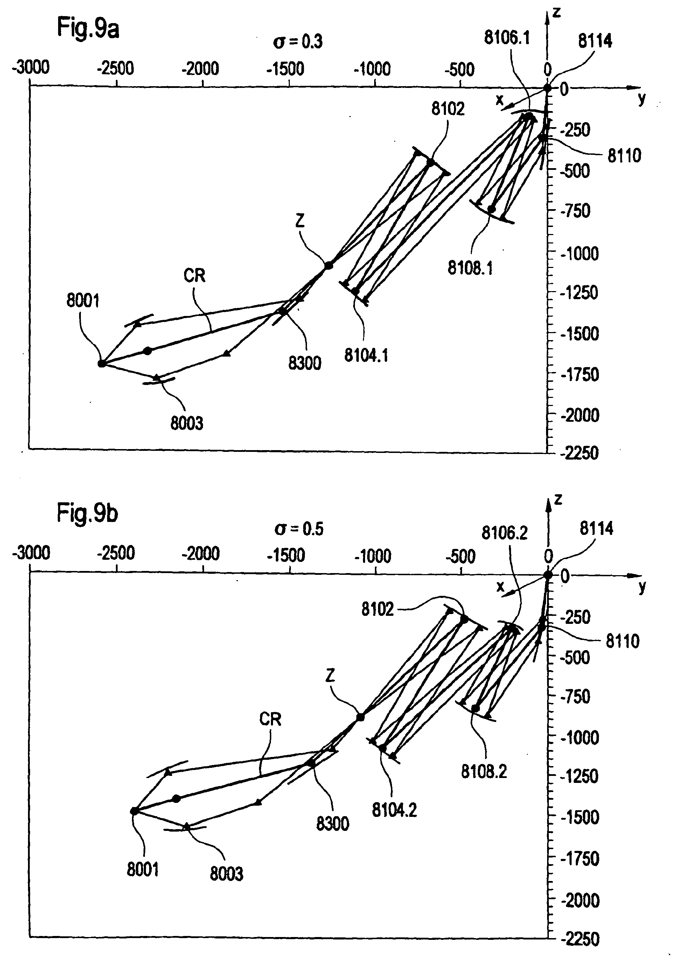

In den Figuren 9a bis 9c sowie in nachfolgender Tabelle 1 ist ein Ausführungsbeispiel der Erfindung angegeben, bei dem durch Verschieben des Pupillenfacettenspiegels gegenüber dem Feldfacettenspiegel und des ersten optischen Elementes bzw. zweiten optischen Elementes der zweiten optischen Komponente wie in Tabelle 1 angegeben eine unterschiedliche Größe der Ausleuchtung der Pupillenebene, d. h. ein unterschiedliches Setting σ eingestellt werden kann. Die Form der Ausleuchtung ist dabei kreisförmig, d.h. es liegt ein kreisförmiges Beleuchtungssetting mit einem einstellbaren Füllgrad σ vor. Der Füllgrad für ein kreisförmiges ist gegeben durch $\sigma = \dfrac{r}{R_{NA}}$.

Die einzelnen Komponenten sind in den Figuren 9a bis 9c mit den selben Bezugsziffern um 8000 erhöht, wie in Figur 1 gekennzeichnet.

Die Radien der Feldfacetten der ersten facettierten Komponente 8102 beträgt R= - 904.25 mm.

Der Radius der Pupillenfacetten des zweiten facettierten optischen Elementes, das in die drei Positionen 8104.1, 8104.2, 8104.3 verbracht wird, beträgt R= - 1090.3 mm. Der Radius des ersten optischen Elementes der zweiten optischen Komponente, die in die Positionen 8106.1, 8106.2 und 8106.3 verbracht werden kann, beträgt R=250.6 mm.

Der Radius des zweiten Elementes der zweiten optischen Komponente das in die Positionen 8108.1, 8108.2, 8108.3 verbracht wird, beträgt R= -829.4 mm. Der feldförmige Spiegel 8110 ist ein asphärischer Spiegel mit einem Radius in x-Richtung von $R_x$= 305.3 mm und einem Radius $R_y$ in y-Richtung von 4716.5 mm. Die Daten beziehen sich auf die jeweiligen lokalen Koordinatensystem der optischen Elemente die durch Translation und Rotation aus dem Koordinatensystem in der Objektebene 8114 zum zentralen Feldpunkt hervorgehen.

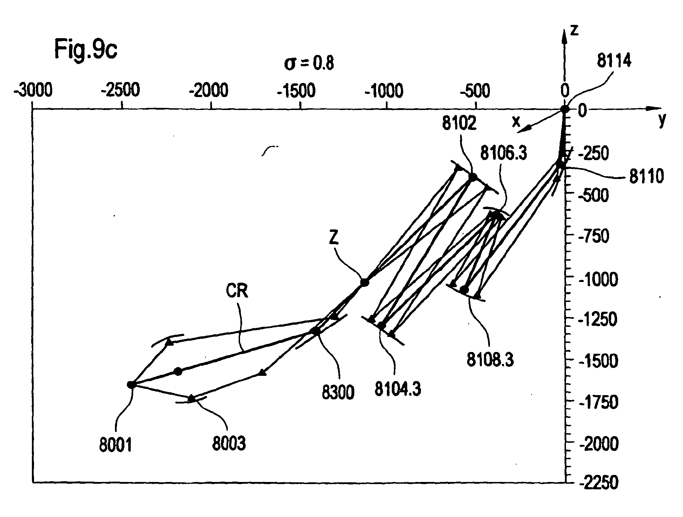

Des Weiteren ist in Figuren 9a, 9b und 9c das lokale Koordinatensystem in der Objektebene 8114 angegeben. Angegeben ist hier die y-Richtung, so wie die z-Richtung und die x-Richtung. Wie aus den Figuren 9a bis 9c hervorgeht, ist das System in einer gemeinsamen Meridonalebene gezeigt, d.h. der Ebene die die z-Achse der einzelnen lokalen Koordinatensysteme umfasst. Die lokalen Koordinatensysteme gehen wie zuvor beschreiben und für den Fachmann bekannt durch Translation und Rotation aus dem Referenz-Koordinatensystem in der Objektebene hervor.

Des Weiteren in Figuren 9a bis 9c angegeben ist der Hauptstrahl CR zum zentralen Feldpunkt des ausgeleuchteten Feldes in der Objektebene 8114. Die Abstände in nachfolgender Tabelle 1 zwischen den einzelnen optischen Elementen ist definiert als der Weg entlang des Hauptstrahles CR der durch den zentralen Feldpunkt in der Feldebene geht und zwischen den einzelnen optischen Komponenten, wenn man den Strahlverlauf in Lichtrichtung verfolgt, verläuft.

In Tabelle 1 sind der Füllgrad σ des Beleuchtungssettings und die Abstände der einzelnen Komponenten wie oben definiert für die Ausführungsbeispiele, die in den Fig. 9a bis 9c gezeigt sind, angegeben. Das Beleuchtungssetting ist ein kreisförmiges Beleuchtungssetting.

Das Beleuchtungssetting kann durch die beschriebenen Abstandsänderungen kontinuierlich eingestellt werden. In Tabelle 1 sind exemplarisch für drei Settingeinstellung mit einem Füllgrad σ=0,3, σ=0.5 und σ=0,8 die genaue Abstände aufgeführt. Man sieht insbesondere, dass eine Settingvariation von mehr als 40% um einen mittleren Füllgrad von σ=0,5 möglich ist. Der versierte Fachmann kann mit Hilfe der obigen Erläuterungen beliebige andere Werte für σ erzeugen.

Tabelle 1

| Abstand zwischen (in mm entlang des Hauptstrahls CR in Lichtrichtung von der Lichtquelle zur Retikelebene) | | | | | | |
|---|---|---|---|---|---|---|
| Fig. | σ | erster facettierte Komponente (8102) und zweiter facettierter Komponente (8104.1, 8104.2, 8104.3 | zweiter facettierte Komponente (8104.1, 8104.2, 8104.3) und erstem optischen Element 8106.1, 8106.2, 8106.3 | ersten optischem Element (8106.1, 8106.2, 8106.3 und zweitem optischen Element (8108.1, 8108.2, 8108.3 | zweitem optischen Element(8108.1, 8108.2, 8108.3) und grazing incidence Spiegel (8110) | Grazing incidence Spiegel 8110 - Retikel (8114) |
| 10a | 0.3 | 913 | 1470 | 600 | 515 | 320 |
| 10b | 0.5 | 957 | 1070 | 550 | 632.8 | 320 |
| 10a | 0.8 | 1038 | 935 | 480 | 909,45 | 320 |

Mit der vorliegenden Erfindung wird erstmals ein Verfahren zum kontinuierlichen Variieren einer Ausleuchtung mit einer Form in einer Pupillenebene eines katoptrischen Beleuchtungssystems angegeben, bei dem die Pupillenausleuchtung, insbesondere die Settingseinstellung durch einfaches Verfahren und Abstandsvariation von optischen Elementen des Beleuchtungssystems erreicht wird.

Insbesondere ist es mit der Erfindung erstmals möglich, in katoptrischen Beleuchtungssystemen, d.h. in reflektiven Beleuchtungssystemen, wie sie bspw. für die EUV-Lithographie eingesetzt werden, eine kontinuierliche Einstellung eines Beleuchtungssettings vorzunehmen. Im Gegensatz zu herkömmlichen Systemen wird bei einer derartigen kontinuierlichen Einstellung zum einen ein Intensitätsverlust, wie er bspw. durch Blenden herbeigeführt werden kann vermieden, zum anderen ist eine kontinuierliche Einstellung möglich.. Des Weiteren handelt es sich bei der angegebenen Art der kontinuierlichen SettingEinstellung um eine sehr einfach zu realisierende Ausgestaltung.

Ein weiterer Vorteil ist, dass die Anzahl der Subpupillen bei geänderten Settingeinstellungen im Wesentlichen gleich bleibt und hierdurch sichergestellt ist, dass die Beleuchtungsstärke in der Feldebene des Beleuchtungssystems sich im Wesentlichen nicht ändert.

**Patentansprüche**

1. Verfahren zum kontinuierlichen Variieren einer Ausleuchtung mit einer Form in einer Pupillenebene (140) eines katoptrischen Beleuchtungssystems, wobei die Form der Ausleuchtung in der Pupillenebene (140) weitgehend erhalten bleibt und die Ausleuchtung in der Pupillenebene (140) eine erste Größe hat,
wobei das katoptrische Beleuchtungssystem aufweist:

   eine Lichtquelle (1), die Strahlung emittiert,
   eine erste optische Komponente (70), die ein erstes facettiertes katoptrisches Element (102) und ein zweites facettiertes katoptrisches Element (104.1, 104.2) aufweist;
   eine zweite optische Komponente (72), die wenigstens ein erstes optisches Element (106) und ein zweites optisches Element (108.1, 108.2) aufweist,
   wobei durch das katoptrische Beleuchtungssystem ein Feld in einer Feldebene (114) ausgeleuchtet wird, und das Verfahren umfasst:

      - Einstellen der Brennweite der zweiten optischen Komponente (72) ergebend eine Ausleuchtung in der Pupillenebene (140) mit einer zweiten Größe
      - Einstellen eines Abstandes zwischen erstem (102) und zweitem facettierten Element (104.1, 104.2) derart, dass die Ausleuchtung in der Feldebene (114), die sich bei der zweiten Größe ergibt, mit der Ausleuchtung in der Feldebene (114), die sich bei der ersten Größe ergibt, übereinstimmt, oder umgekehrt.

2. Verfahren nach Anspruch 1, wobei die Strahlung eine Wellenlänge $\lambda$ aufweist und die Wellenlänge $\lambda \leq 193$ nm ist.

3.  Verfahren nach Anspruch 2, wobei die Wellenlänge $\lambda \leq 14$ nm ist.

4.  Verfahren nach einem der Ansprüche 1 bis 3, wobei die zweite Größe gegenüber der ersten Größe um $\pm$ 10 % variiert.

5.  Verfahren nach einem der Ansprüche 1 bis 3, wobei die zweite Größe gegenüber der ersten Größe um $\pm$ 25 % variiert.

6.  Verfahren nach einem der Ansprüche 1 bis 3, wobei die zweite Größe gegenüber der ersten Größe um $\pm$ 40 % variiert.

7.  Verfahren nach einem der Ansprüche 1 bis 6, wobei die Ausleuchtung in der Pupillenebene kreisförmig ist.

8.  Verfahren nach einem der Ansprüche 1 bis 6, wobei die Ausleuchtung in der Pupillenebene annular ist.

9.  Verfahren nach einem der Ansprüche 1 bis 6, wobei die Ausleuchtung in der Pupillenebene multipolar ist.

10. Verfahren nach einem der Ansprüche 1 bis 6, wobei die Ausleuchtung in der Pupillenebene (140) dipolar ist.

11. Verfahren nach einem der Ansprüche 1 bis 6, wobei die Ausleuchtung in der Pupillenebene (140) quadrupolar ist.

12. Verfahren nach einem der Ansprüche 7 bis 8, wobei die Größe der Ausleuchtung in der Pupillenebene (140) durch einen Füllgrad σ charakterisiert wird und die erste Größe der Ausleuchtung in der Pupillenebene einem ersten Füllgrad σ (1) und die zweite Größe der Ausleuchtung in der Pupillenebene (140) einem zweiten Füllgrad σ (2) entspricht und
σ (2) um $\pm$ 40% gegenüber σ(1) variiert, d.h. im Bereich

$$(1 + 0{,}40) \cdot \sigma(1) > \sigma(2) > (1 - 0{,}40) \cdot \sigma(1)$$

liegt.

13. Verfahren nach einem der Ansprüche 7 bis 8, wobei die Größe der Ausleuchtung in der Pupillenebene (140) durch einen Füllgrad σ charakterisiert wird und die erste Größe der Ausleuchtung in der Pupillenebene (140) einem ersten Füllgrad σ (1) und die zweite Größe der Ausleuchtung in der Pupillenebene (140) einem zweiten Füllgrad σ (2) entspricht und
σ (2) um $\pm$ 25% gegenüber σ(1) variiert, d.h. im Bereich

$$(1 + 0{,}25) \cdot \sigma(1) > \sigma(2) > (1 - 0{,}25) \cdot \sigma(1)$$

liegt.

14. Verfahren nach einem der Ansprüche 7 bis 8, wobei die Größe der Ausleuchtung in der Pupillenebene (140) durch einen Füllgrad σ charakterisiert wird und die erste Größe der Ausleuchtung in der Pupillenebene (140) einem ersten Füllgrad σ (1) und die zweite Größe der Ausleuchtung in der Pupillenebene (140) einem zweiten Füllgrad σ (2) entspricht und
σ (2) um $\pm$ 10% gegenüber σ(1) variiert, d.h. im Bereich

$$(1 + 0{,}10) \cdot \sigma(1) > \sigma(2) > (1 - 0{,}10) \cdot \sigma(1)$$

liegt.

15. Verfahren nach einem der Ansprüche 1 bis 14, wobei das erste facettierte katoptrische Element (102) erste Rasterelemente (2005) umfasst, wobei die ersten Rasterelemente (2005) die Feldform des Feldes in der Feldebene (114) aufweisen.

**16.** Verfahren nach einem der Ansprüche 1 bis 14, wobei die Brennweite der zweiten optischen Komponente (72) durch eine Änderung des Abstandes zwischen einer der nachfolgenden optischen Elemente der ersten optischen Komponente (70) oder der zweiten optischen Komponente (72) eingestellt wird:

    - dem Abstand zwischen zweitem facettierten katoptrischen Element (104.1, 104.2) und erstem optischen Element (106).
    - dem Abstand zwischen erstem (106) und zweitem optischen Element (108.1, 108.2).
    - dem Abstand zwischen zweitem optischen Element (108.1, 108.2) und Feldebene (114).

**17.** Verfahren nach einem der Ansprüche 1 bis 14, wobei das erste facettierte katoptrische Element (102) erste Rasterelemente (2005) umfasst, wobei die ersten Rasterelemente (2005) eine rechteckige Form aufweisen.

**Claims**

**1.** Method for continuously varying an illumination having a shape in a pupil plane (140) of a catoptric illumination system, the shape of the illumination in the pupil plane (140) largely being maintained, and the illumination in the pupil plane (140) having a first size,
in which the catoptric illumination system has:

    a light source (1) which emits radiation,
    a first optical component (70), which has a first facetted catoptric element (102) and a second facetted catoptric element (104.1, 104.2),
    a second optical component (72), which has at least a first optical element (106) and a second optical element (108.1, 108.2),
    the catoptric illumination system illuminating a field in a field plane (114), and the method comprising:

    - setting the focal length of the second optical component (72) to yield an illumination in the pupil plane (140) having a second size,
    - setting a distance between a first (102) and a second facetted element (104.1, 104.2) in such a way that the illumination in the field plane (114) which is yielded for the second size corresponds to the illumination in the field plane (114) which is yielded for the first size, or vice versa.

**2.** Method according to Claim 1, in which the radiation has a wavelength $\lambda$, and the wavelength $\lambda \leq 193$ nm.

**3.** Method according to Claim 2, in which the wavelength $\lambda \leq 14$ nm.

**4.** Method according to one of Claims 1 to 3, in which the second size varies by $\pm$ 10% in relation to the first size.

**5.** Method according to one of Claims 1 to 3, in which the second size varies by $\pm$ 25% in relation to the first size.

**6.** Method according to one of Claims 1 to 3, in which the second size varies by $\pm$ 40% in relation to the first size.

**7.** Method according to one of Claims 1 to 6, in which the illumination in the pupil plane is circular.

**8.** Method according to one of Claims 1 to 6, in which the illumination in the pupil plane is annular.

**9.** Method according to one of Claims 1 to 6, in which the illumination in the pupil plane is multipolar.

**10.** Method according to one of Claims 1 to 6, in which the illumination in the pupil plane (140) is dipolar.

**11.** Method according to one of Claims 1 to 6, in which the illumination in the pupil plane (140) is quadrupolar.

**12.** Method according to either of Claims 7 and 8, in which the size of the illumination in the pupil plane (140) is **characterized by** a filling degree $\sigma$, and the first size of the illumination in the pupil plane corresponds to a first filling degree $\sigma(1)$ and the second size of the illumination in the pupil plane (140) corresponds to a second filling degree $\sigma(2)$, and $\sigma(2)$ varies by $\pm$ 40% in relation to $\sigma(1)$, that is to say lies in the range

$$(1 + 0.40) \cdot \sigma(1) > \sigma(2) > (1 - 0.40) \cdot \sigma(1).$$

13. Method according to either of Claims 7 and 8, in which the size of the illumination in the pupil plane (140) is **characterized by** a filling degree σ and the first size of the illumination in the pupil plane (140) corresponds to a first filling degree σ(1) and the second size of the illumination in the pupil plane (140) corresponds to a second filling degree σ(2), and σ(2) varies by ± 25% in relation to σ(1), that is to say lies in the range

$$(1 + 0.25) \cdot \sigma(1) > \sigma(2) > (1 - 0.25) \cdot \sigma(1).$$

14. Method according to either of Claims 7 and 8, in which the size of the illumination in the pupil plane (140) is **characterized by** a filling degree σ and the first size of the illumination in the pupil plane (140) corresponds to a first filling degree σ(1) and the second size of the illumination in the pupil plane (140) corresponds to a second filling degree σ(2), and σ(2) varies by ± 10% in relation to σ(1), that is to say lies in the range

$$(1 + 0.10) \cdot \sigma(1) > \sigma(2) > (1 - 0.10) \cdot \sigma(1).$$

15. Method according to one of Claims 1 to 14, in which the first facetted catoptric element (102) comprises first raster elements (2005), the first raster elements (2005) having the field shape of the field in the field plane (114).

16. Method according to one of Claims 1 to 14, in which the focal length of the second optical component (72) is set by changing the distance between one of the downstream optical elements of the first optical component (70) or the second optical component (72):

    - the distance between second facetted catoptric element (104.1, 104.2) and first optical element (106),
    - the distance between first (106) and second optical element (108.1, 108.2),
    - the distance between second optical element (108.1, 108.2) and field plane (114).

17. Method according to one of Claims 1 to 14, in which the first facetted catoptric element (102) comprises first raster elements (2005), the first raster elements (2005) having a rectangular shape.

**Revendications**

1. Procédé pour la variation continue d'une illumination avec une forme dans un plan de la pupille (140) d'un système d'éclairage catoptrique, dans lequel la forme de l'illumination dans le plan de la pupille (140) est largement conservée et l'illumination dans le plan de la pupille (140) a une première dimension,
dans lequel le système d'éclairage catoptrique comporte :

    une source lumineuse (1) émettant du rayonnement,
    un premier composant optique (70) comportant un premier élément catoptrique à facettes (102) et un deuxième élément catoptrique à facettes (104.1, 104.2) ;
    un deuxième composant optique (72) comportant au moins un premier élément optique (106) et un deuxième élément optique (108.1, 108.2),

    dans lequel on illumine un champ dans un plan du champ (114) au moyen du système d'éclairage catoptrique, et le procédé comprenant :

    - le réglage de la distance focale du deuxième composant optique (72) produisant une illumination d'une deuxième dimension dans le plan de la pupille (140),

- le réglage d'une distance entre le premier élément à facettes (102) et le deuxième (104.1, 104.2) de telle sorte que l'illumination produite dans le plan du champ (114) dans la deuxième dimension, coïncide avec l'illumination produite dans le plan du champ (114) dans la première dimension, ou réciproquement.

2. Procédé selon la revendication 1, dans lequel le rayonnement présente une longueur d'onde $\lambda$ et la longueur d'onde est de $\lambda \leq 193$ nm.

3. Procédé selon la revendication 2, dans lequel la longueur d'onde est de $\lambda \leq 14$ nm.

4. Procédé selon une des revendications 1 à 3, dans lequel la deuxième dimension varie de $\pm$ 10% par rapport à la première dimension.

5. Procédé selon une des revendications 1 à 3, dans lequel la deuxième dimension varie de $\pm$ 25% par rapport à la première dimension.

6. Procédé selon une des revendications 1 à 3, dans lequel la deuxième dimension varie de $\pm$ 40% par rapport à la première dimension.

7. Procédé selon une des revendications 1 à 6, dans lequel l'illumination dans le plan de la pupille est de forme circulaire.

8. Procédé selon une des revendications 1 à 6, dans lequel l'illumination dans le plan de la pupille est annulaire.

9. Procédé selon une des revendications 1 à 6, dans lequel l'illumination dans le plan de la pupille est multipolaire.

10. Procédé selon une des revendications 1 à 6, dans lequel l'illumination dans le plan de la pupille (140) est dipolaire.

11. Procédé selon une des revendications 1 à 6, dans lequel l'illumination dans le plan de la pupille (140) est quadripolaire.

12. Procédé selon une des revendications 7 à 8, dans lequel la dimension de l'illumination dans le plan de la pupille (140) est **caractérisée par** un taux de remplissage $\sigma$ et la première dimension de l'illumination dans le plan de la pupille correspond à un premier taux de remplissage $\sigma(1)$ et la deuxième dimension de l'illumination dans le plan de la pupille (140) correspond à un deuxième taux de remplissage $\sigma(2)$ et
$\sigma(2)$ varie de $\pm$ 40% par rapport à $\sigma(1)$, c'est-à-dire qu'il se situe dans la plage

$$(1 + 0,40) \cdot \sigma(1) > \sigma(2) > (1 - 0,40) \cdot \sigma(1).$$

13. Procédé selon une des revendications 7 à 8, dans lequel la dimension de l'illumination dans le plan de la pupille (140) est **caractérisée par** un taux de remplissage $\sigma$ et la première dimension de l'illumination dans le plan de la pupille (140) correspond à un premier taux de remplissage $\sigma(1)$ et la deuxième dimension de l'illumination dans le plan de la pupille (140) correspond à un deuxième taux de remplissage $\sigma(2)$ et
$\sigma(2)$ varie de $\pm$ 25% par rapport à $\sigma(1)$, c'est-à-dire qu'il se situe dans la plage

$$(1 + 0,25) \cdot \sigma(1) > \sigma(2) > (1 - 0,25) \cdot \sigma(1).$$

14. Procédé selon une des revendications 7 à 8, dans lequel la dimension de l'illumination dans le plan de la pupille (140) est **caractérisée par** un taux de remplissage $\sigma$ et la première dimension de l'illumination dans le plan de la pupille (140) correspond à un premier taux de remplissage $\sigma(1)$ et la deuxième dimension de l'illumination dans le plan de la pupille (140) correspond à un deuxième taux de remplissage $\sigma(2)$ et
$\sigma(2)$ varie de $\pm$ 10% par rapport à $\sigma(1)$, c'est-à-dire qu'il se situe dans la plage

$$(1 + 0,10) \cdot \sigma(1) > \sigma(2) > (1 - 0,10) \cdot \sigma(1).$$

**15.** Procédé selon une des revendications 1 à 14, dans lequel le premier élément catoptrique à facettes (102) comporte des premiers éléments de balayage (2005), les premiers éléments de balayage (2005) présentant la forme du champ dans le plan du champ (114).

**16.** Procédé selon une des revendications 1 à 14, dans lequel la distance focale du deuxième composant optique (72) est réglée par une modification de la distance entre un des éléments optiques suivants du premier composant optique (70) ou du deuxième composant optique (72) :

- la distance entre le deuxième élément catoptrique à facettes (104.1, 104.2) et le premier élément optique (106),
- la distance entre le premier élément optique (106) et le deuxième élément optique (108.1, 108.2),
- la distance entre le deuxième élément optique (108.1, 108.2) et le plan du champ (114).

**17.** Procédé selon une des revendications 1 à 14, dans lequel le premier élément catoptrique à facettes (102) comporte des premiers éléments de balayage (2005), les premiers éléments de balayage (2005) présentant une forme rectangulaire.

Fig.1a

Fig.1b

Fig.1c

Fig.1d

Fig.1e

EP 1 845 417 B1

Fig.2

Fig.3

Fig.4

Fig.5

## Fig.6

5102
5104
5007
5104
5001
5002

## Fig.7

6106 6106
z
y
x
6102
z
y
z
dz2.1
x
6110
Z
6108
dz1.1
z
z
dz2.2
x
y
6104
6108
6104

Fig.8

Fig.9a

Fig.9b

Fig.9c

σ = 0.8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6198793 B
- US 6438199 B
- US 6195201 B
- US 6658084 B
- US 6704095 B
- US 5237367 A
- WO 2006021419 A
- US 20020186811 A1
- US 20030043455 A1
- US 20020136351 A1
- US 6600552 B2